(19) Europäisches Patentamt
European Patent Office
Office européen des brevets

(11) EP 1 424 350 B1

(12) # EUROPEAN PATENT SPECIFICATION

(45) Date of publication and mention of the grant of the patent:
**27.08.2014 Bulletin 2014/35**

(21) Application number: **02765394.8**

(22) Date of filing: **30.08.2002**

(51) Int Cl.:
***C08F 226/02*** (2006.01) ***C08G 61/12*** (2006.01)
***C09K 11/06*** (2006.01) ***H05B 33/14*** (2006.01)
***H01L 51/30*** (2006.01) ***H01L 51/50*** (2006.01)

(86) International application number:
**PCT/JP2002/008839**

(87) International publication number:
**WO 2003/018653 (06.03.2003 Gazette 2003/10)**

(54) **PHOSPHOR LIGHT-EMITTING COMPOUND, PHOSPHOR LIGHT-EMITTING COMPOSITION, AND ORGANIC LIGHT EMITTING ELEMENT**

LICHTEMITTIERENDE LEUCHTSTOFFVERBINDUNG, LICHTEMITTIERENDE LEUCHTSTOFFZUSAMMENSETZUNG UND ORGANISCHES LICHTEMITTIERENDES ELEMENT

COMPOSE PHOSPHORESCENT, COMPOSITION PHOSPHORESCENTE ET ELEMENT LUMINESCENT ORGANIQUE

(84) Designated Contracting States:
**AT BE BG CH CY CZ DE DK EE ES FI FR GB GR IE IT LI LU MC NL PT SE SK TR**

(30) Priority: **31.08.2001 JP 2001265033**
**20.03.2002 JP 2002079129**
**15.04.2002 JP 2002112352**

(43) Date of publication of application:
**02.06.2004 Bulletin 2004/23**

(60) Divisional application:
**09010816.8 / 2 159 237**
**09011012.3 / 2 154 165**

(73) Proprietors:
- **NIPPON HOSO KYOKAI**
  **Tokyo 150-8001 (JP)**
  Designated Contracting States:
  **DE FR GB**
- **Showa Denko K.K.**
  **Tokyo 105-8518 (JP)**

(72) Inventors:
- **TOKITO, Shizuo,**
  **NHK Science & Tech. Res. Labs.**
  **Tokyo 157-8510 (JP)**
- **SUZUKI, Mitsunori,**
  **NHK Science & Tech. Res. Labs.**
  **Tokyo 157-8510 (JP)**
- **TANAKA, Isao,**
  **NHK Science & Tech. Res. Labs.**
  **Tokyo 157-8510 (JP)**
- **INOUE, Youji,**
  **NHK Science & Tech. Res. Labs.**
  **Tokyo 157-8510 (JP)**
- **SHIRANE, Koro,**
  **SHOWA DENKO K.K.**
  **Chiba-shi, Chiba 267-0056 (JP)**
- **TAKEUCHI, Masataka,**
  **SHOWA DENKO K.K.**
  **Chiba-shi, Chiba 267-0056 (JP)**
- **ITO, Naoko,**
  **SHOWA DENKO K.K.**
  **Chiba-shi, Chiba 267-0056 (JP)**

(74) Representative: **Strehl Schübel-Hopf & Partner**
**Maximilianstrasse 54**
**80538 München (DE)**

(56) References cited:
**EP-A1- 0 612 772** **EP-A1- 0 850 960**
**EP-A1- 0 992 564** **EP-A1- 1 006 169**
**EP-A2- 0 735 055** **EP-A2- 0 825 207**
**JP-A- 8 048 726** **JP-A- 8 157 815**
**JP-A- 10 001 665** **JP-A- 2001 151 868**
**JP-A- 2002 293 830** **US-A- 5 272 238**
**US-A1- 2001 015 432**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- **LAMANSKY S ET AL: "MOLECULARLY DOPED POLYMER LIGHT EMITTING DIODES UTILIZING PHOSPHORESCENT PT(II) AND IR(III) DOPANTS" ORGANIC ELECTRONICS, ELSEVIER, AMSTERDAM, NL, vol. 2, no. 1, March 2001 (2001-03), pages 53-62, XP001100541 ISSN: 1566-1199**
- **TERUJI KOSE ET AL.: 'Handbook of Optical Engineering', ASAKURA PUBLISHING CO., LTD. pages 118 - 119**


Remarks:

The file contains technical information submitted after the application was filed and not included in this specification

**Description**

TECHNICAL FIELD

The present invention relates to an organic polymeric phosphorescent compound used as a material for an organic light-emitting device, a phosphorescent composition, an organic light-emitting device, and a display apparatus.

BACKGROUND ART

For a display apparatus such as a flat panel display or a lighting fixture such as a back light, an organic light-emitting device emitting an electroluminescence from a thin film made from an organic compound has been noted as a device by which a bright luminescence can be obtained at a low voltage.

Research and development for an increase in surface area employing a luminescent organic polymer soluble in an organic solvent or water are performed actively with respect to a styrene-based or fluorene-based organic polymer as a material of a film in an organic light-emitting device. As a method for forming a film of such an organic polymer, a wet process such as a spin-coating method, a printing method, and an ink-jet method have been utilized. In particular, the ink-jet method is envisaged as a realistic method for creating pixels of a display screen in a full color display and a compact full-color prototype panel has already been disclosed.

On the other hand, research for great improvement of emission efficiency with respect to low-molecular compounds of which a film is formed by a vacuum deposition method has been performed actively and an organometallic compound with platinum or iridium, utilizing phosphorescence that is an emission from a triplet excited state of an organic compound, has been reported. An external emission quantum yield for an organic light-emitting device utilizing this phosphorescent compound exceeds 5 % for a conventional device utilizing fluorescence and a high efficiency of 8 % was obtained, and recently, even a very high efficiency of 15 % has been obtained by devising a structure of a device (Appl. Phys. Lett., 77, 904 (2000)).

There is a research report for a dope-type organic polymer light-emitting device in which this low-molecular phosphorescent compound is dispersed into an organic polymer, and for such a device that an iridium complex is doped into poly(N-vinylcarbazole) (PVK), the value of approximately 4 % was obtained as an external emission quantum yield and a large improvement is appreciated (Jpn. J. Appl. Phys, 39, L28 (2000)). Also, for an organic polymer containing a ruthenium complex, an electrochemical luminescence was reported (J. Mater. Chem., 9, 2103 (1999)).

US 2001/0015432 discloses light emitting polymers comprising charge transporting and phosphorescent units.

However, a conventional organic polymer light-emitting device, for which it is intended to realize an increase in surface area at low cost, has not yet been sufficient in respect to emission efficiency. The cause is that the theoretical external emission efficiency has an upper limit of 5 % since fluorescence that is luminescence from a singlet excited state of a conventional organic polymer is utilized. Although an organic polymer light-emitting device has a major feature in that a film of an organic polymer layer can be formed from a solution in an organic solvent or water by a wet process, further improvement of emission efficiency is a problem for practice in the future.

Also, gaining great improvement of emission efficiency has been tried by dispersing a low-molecular phosphorescent compound into an organic polymer light-emitting device, but the low-molecular one dispersed into a host polymer is not stable and a display apparatus with a long service life and a reliability over a long period cannot be realized.

Therefore, taking the future realization of an organic light-emitting device into consideration, development of a novel organic polymeric luminescent material is desired, of which a film is formed from a solution in an organic solvent or water by a wet process, thereby an increase in surface area can be realized at low cost, which is stable, that is, has a long service life, and for which very highly efficient emission can be realized.

DISCLOSURE OF THE INVENTION

The present invention is provided taking the above problems into consideration and is directed at providing an organic polymeric phosphorescent compound and a phosphorescent composition that are stable and emit very highly efficient phosphorescence, to be used as a material of an organic light-emitting device.

Also, the present invention is directed at providing an organic light-emitting device employing the organic polymeric phosphorescent compound or the phosphorescent composition and an display apparatus employing this organic light-emitting device.

To achieve this object, the invention as claimed in claim 1 is a non-ionic organic polymeric phosphorescent compound emitting phosphorescence and used in an organic light-emitting device, characterized in that a phosphorescent unit being a repeat unit for emitting phosphorescence and a carrier transporting unit being a repeat unit for transporting a carrier are included as defined in claim 1.

According to the invention as claimed in claim 1, an organic polymeric phosphorescent compound which is

stable and emits very highly efficient phosphorescence, used as a material of an organic light-emitting device, can be provided, since the non-ionic organic phosphorescent compound emitting phosphorescence and used in an organic light-emitting device includes the phosphorescent unit being a repeat unit for emitting phosphorescence and the carrier transporting unit being a repeat unit for transporting a carrier.

Further embodiments are described in the dependent claims.

BRIEF DESCRIPTION OF THE DRAWINGS

FIG. 1 is a diagram illustrating a typical structure of a phosphorescent compound of an organic polymer according to the present invention.

FIG. 2 is a diagram illustrating a laminated structure of an organic light-emitting device according to the present invention.

FIG. 3 is a diagram showing an emission spectrum of the organic light-emitting device fabricated in example 6-3.

FIG. 4 is a diagram showing an emission spectrum of the organic light-emitting device fabricated in example 7-2.

BEST MODE FOR CARRYING OUT THE INVENTION

Next, embodiments of the present invention will be illustrated by reference to the drawings.

The present invention is an invention for an organic polymeric phosphorescent compound, which includes repeat units emitting phosphorescence (referred to as a phosphorescent unit) and a repeat unit transporting a carrier such as an electron or a hole (referred to as a carrier transporting unit), used as a material for an organic light-emitting device. The organic polymeric phosphorescent compound according to the present invention may be a random copolymer of which phosphorescent units and a carrier transporting unit are arranged randomly in a polymer chain, and is a non-ionic, that is, neutral polymer. In the phosphorescent compound according to the present invention, stability and a long service life are provided since the phosphorescent units and the carrier transporting units are linked in a polymer chain and aggregation of the phosphorescent units is suppressed, and further a very highly efficient emission can be realized since phosphorescent, not fluorescent, units are included.

Typically, as shown in FIG. 1, the structure of the phosphorescent compound according to the present invention is classified, due to the types of monomers forming the phosphorescent units and the carrier transporting units, into four cases: (a) the case where the phosphorescent sites and the carrier transporting sites are together in a main chain of the polymer, (b) the case where the phosphorescent sites are in side chains of the polymer and the carrier transporting sites are in the main chain of the polymer, (c) the case where the phosphorescent sites are in the main chain of the polymer and the carrier transporting sites are in the side chains of the polymer, and (d) the case where the phosphorescent sites and the carrier transporting sited are together in the side chains of the polymer. Herein, the phosphorescent site represents a portion having a function of emitting phosphorescence in the phosphorescent unit and the carrier transporting site represents a portion having a function of transporting a carrier in the carrier transporting unit.

Herein, it is desired that at least one of the phosphorescent site and the carrier transporting site bond, as a side chain, to the main chain of the polymer of the phosphorescent compound (FIG. 1(b)-(d)). In this case, it is easy to synthesize the phosphorescent compound and a phosphorescent compound that is easy to dissolve in an organic solvent can be provided.

Furthermore, in order to provide a phosphorescent site of which emission efficiency of phosphorescence is high, it is desired that the phosphorescent site be a monovalent group and a divalent group of a complex with a transition metal or a rare earth metal.

As examples of the phosphorescent sites, provided is a monovalent group or a divalent group of a transition metal complex or a monovalent group or a divalent group of a rare earth metal complex including a ligand selected from the group showing:

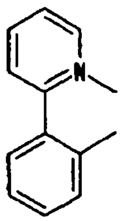
R-1

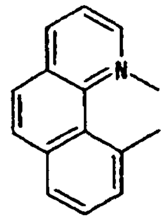
R-2

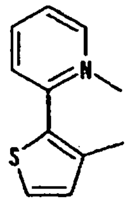
R-3

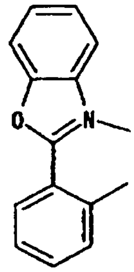
R-4

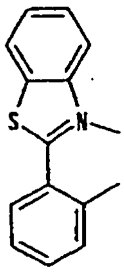
R-5

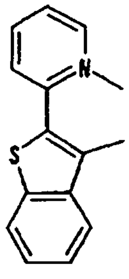
R-6

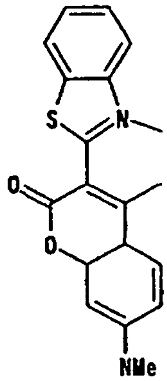
R-7

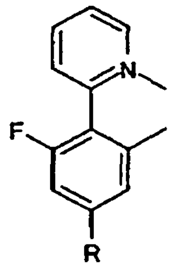
R-8

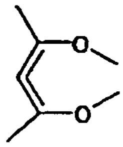
acac

The transition metals used in the above mentioned transition metal complex include the first transition element series of the periodic table, that is, Sc with the atomic number of 21 through Zn with the atomic number of 30; the second transition element series, that is, Y with the atomic number of 39 through Cd with the atomic number of 48; and the third transition element series, that is, Hf with the atomic number of 72 through Hg with the atomic number of 80. Also, the rare earth metals used in the above mentioned rare earth metal complex include the lanthanide series of the periodic table, that is, La with the atomic number of 57 through Lu with the atomic number of 71. Furthermore, the ligand may be a ligand different from the above-mentioned ligands.

Examples of the carrier transporting sites with high carrier transporting property are different between the case where the organic polymeric phosphorescent compound according to the present invention is a hole transporting polymer and the case where the organic polymeric phosphorescent compound according to the present invention is an electron transporting polymer.

In the case of the hole transporting polymer, monovalent groups of carbazole (HT-1) being a tertially amine, triphenylamine (HT-2), a multimer thereof (HT-3), etc. as shown in

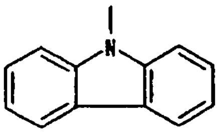
HT-1

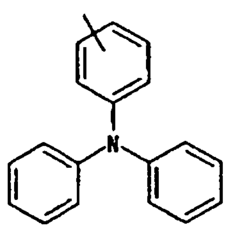
HT-2

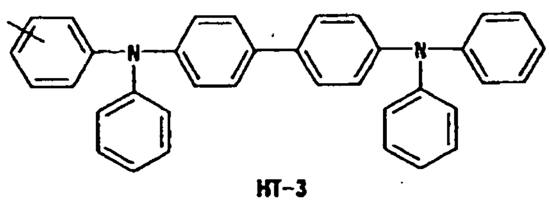
HT-3

are typical and these monovalent groups may be substituted with a substituent.

In the case of the electron transporting polymer, monovalent groups of oxadiazole derivatives (ET-1, 2), triazole derivatives (ET-4), or imidazole derivatives (ET-3) as shown in

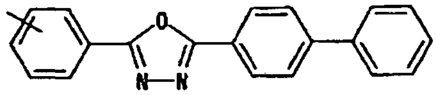

ET-1

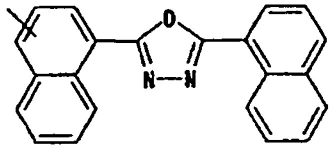

ET-2

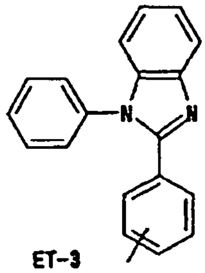

ET-3

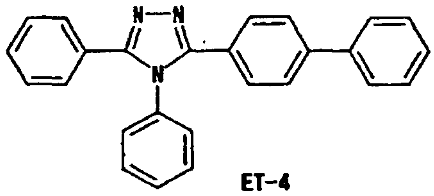

ET-4

are provided. Aromatic rings in the monovalent groups of these derivatives may be substituted with a substituent. Also, a divalent group of thiophene (TF), a divalent group of benzene (PP), a divalent group of styrene (PV), or a divalent group of fluorene (FO), substituted with a substituent, having a capability of transporting a hole and forming a polymer of which a main chain is a conjugate system in fluorescent polymers, as shown in

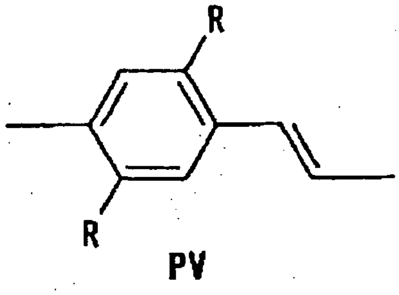

PV

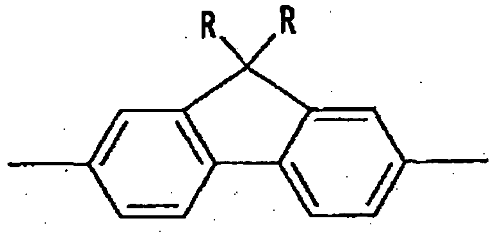

FO

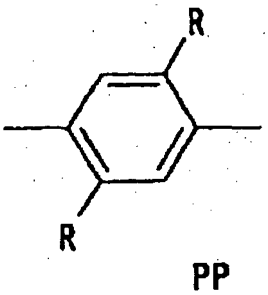

PP

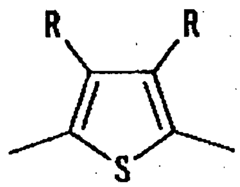

TF

may be employed. Herein, substituent R represents an alkyl group or an alkoxy group. In the phosphorescent compound according to the present invention, these divalent groups are incorporated into the main chain of the polymer as carrier transporting sites.

As examples of copolymers including the above mentioned repeat units, provided are polymers (P1, P3, P4) having a monovalent group of a iridium complex or a platinum complex of the phosphorescent site and a monovalent group of carbazole or a derivative thereof as the hole (carrier) transporting site to the side chains of the vinyl structure being the main chain, and also a polymer (P2) using a monovalent group of an oxadiazole derivative as the electron (carrier) transporting site to the side chains, as shown in

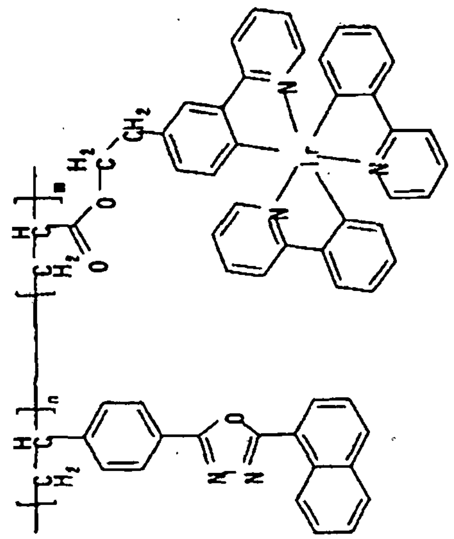

P2

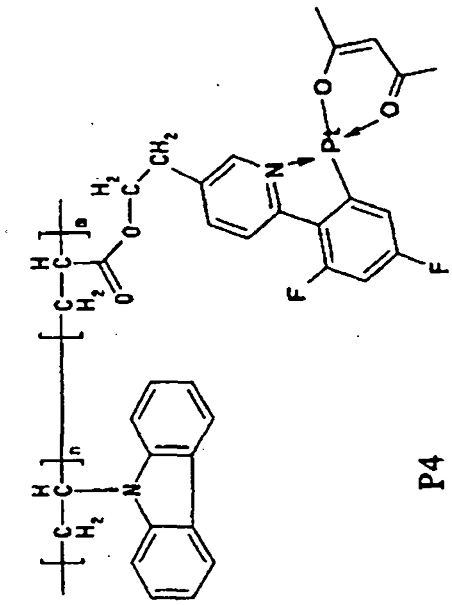

P4

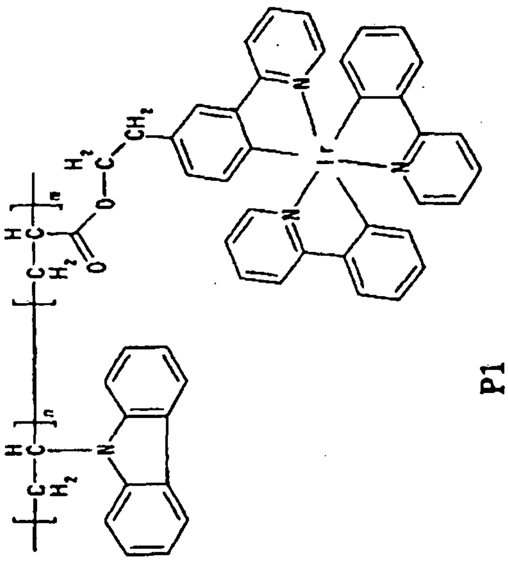

P1

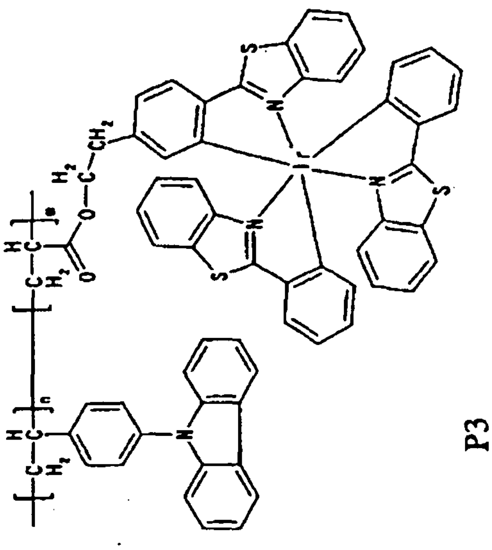

P3

These copolymers can be synthesized via a radical copolymerization using a reaction initiator from a vinyl compound. A monomer in which a polymerizable functional group is introduced to one of ligands of an iridium complex is synthesized, for example, by the following method. The synthesis method is such a method that an intermediate in which one reactive substituent (hydroxyl group, amino group, etc.) has been introduced to each of the three ligands is prepared, this intermediate and a compound having a polymerizable functional group (polymerizable acid halides, polymerizable isocyanate, etc.) are reacted at a molar ratio close to 1:1, and the product is purified to obtain a monofunctional monomer. Furthermore, after the above-mentioned reaction, in order to render reactive substituents remaining in the product non-reactive, the product and a non-polymerizable compound (alkyl halides, carboxylic acid halides, etc.) are reacted.

Moreover, also provided is a copolymer with such a structure that one of the ligands of the iridium complex is acetylaceton or picolinic acid and the iridium complex bonds to the main chain of the polymer via this acetylaceton, etc. as shown in

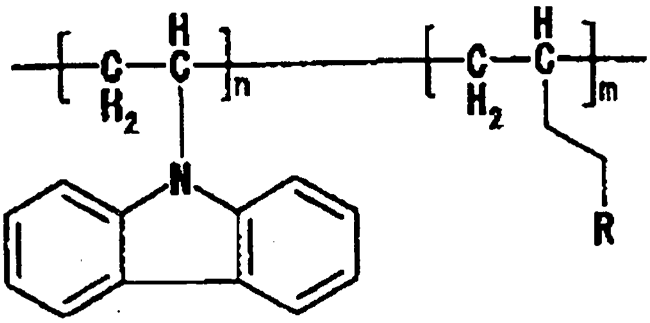

R=

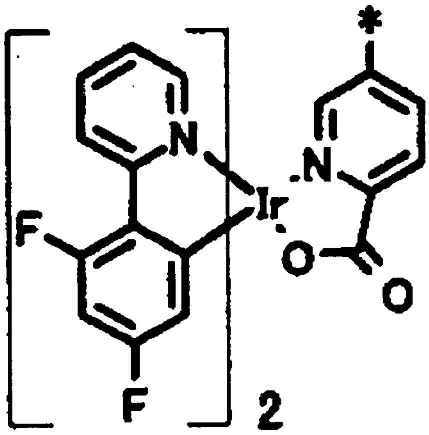

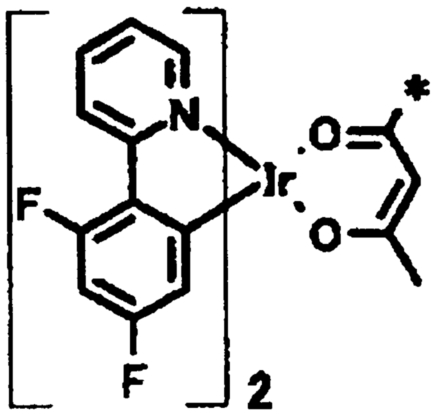

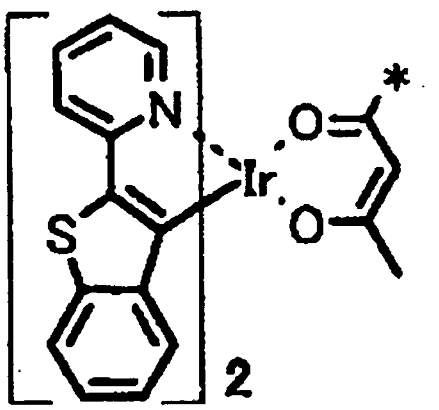

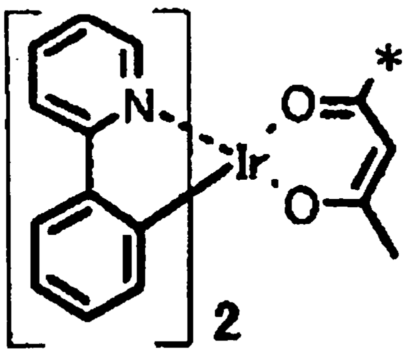

Herein, * marks in the chemical formulas denote portions (bonds) connecting to substituents R shown in the chemical formulas of the polymer.

As described above, a monomer of an iridium complex in which two kinds of ligands (those of which two are coordinated are referred to as first ligands and those of which one is coordinated are referred to as second ligands) is introduced and a polymerizable functional group to the second ligand is included, is synthesized, for example, by the following method. The synthesis method is such a method that a binuclear complex with iridium synthesized by the well-known method (S. Lamansky, et. al., Inorganic Chemistry, 40, 1704(2001)) and the second ligand having a polymerizable functional group are reacted to obtain a mononuclear iridium complex having a polymerizable functional group. Also, the binuclear complex and a second ligand having a reactive substituent may be reacted to obtain a mononuclear iridium complex having a reactive substituent, and this and a compound having a polymerizable functional group may be reacted to obtain a mononuclear iridium complex having a polymerizable functional group.

Also, as the above-mentioned copolymer, when a transition metal complex portion of an iridium complex, etc. or a rare earth metal complex portion as the phosphorescent site bonds, as a side chain, to a main chain of the polymer, it is preferable that a spacer portion be interposed between a monovalent group of the transition metal complex or the rare earth metal complex and the main chain of the polymer.

The spacer portion is a portion bonding between a multivalent atom to which an atom allowable to be substituted bonds in the polymer compound constituting a main chain and a multivalent atom to which an atom allowable to be substituted bonds in a low-molecular compound forming the basis of phosphorescent site. It is preferable that such a spacer portion be a structure including an organic group in which the number of carbons is 1 through 30 and a hetero atom may be contained or an inorganic group in which the number of hetero atoms is 1 through 10 and a carbon atom not be contained.

As the spacer portion, for example, an alkylene group in which the number of carbons is 1 through 20, and linking groups such as (S-1) through (S-15), etc. as shown .in

(S-1)

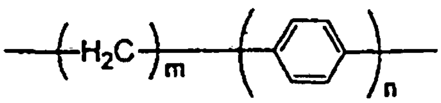

(S-2)

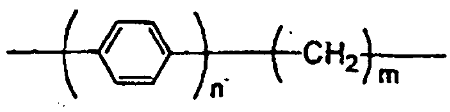

(S-3)

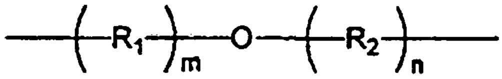

(S-4)

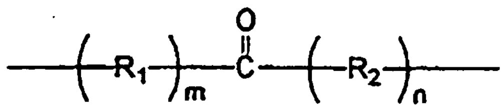

(S-5)

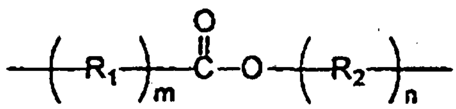

(S-6)

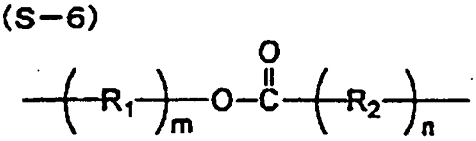

(S-7)

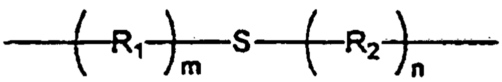

(S-8)

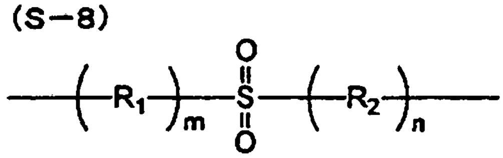

(S-9)

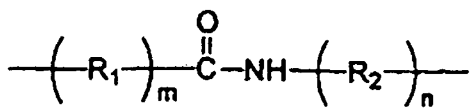

(S-10)

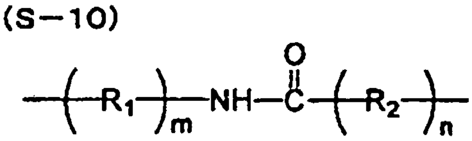

(S-11)

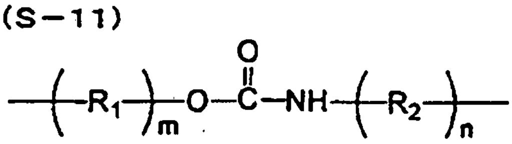

(S-12)

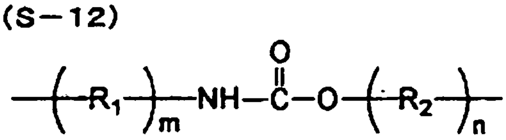

(S-13)

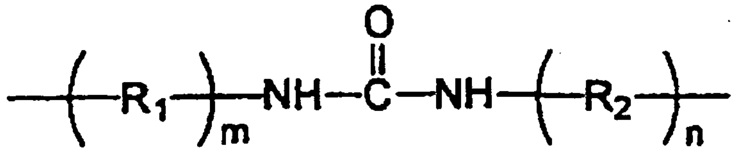

(S-14)

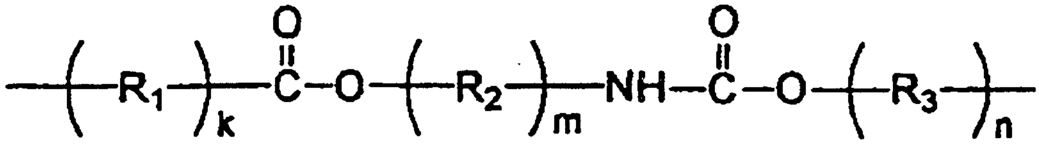

(S-15)

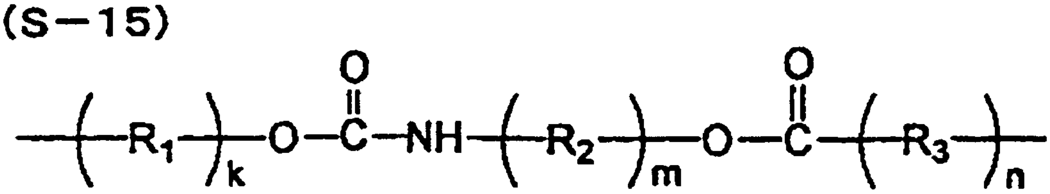

can be provided, but are not limited to them.

Furthermore, in (S-1) through (S-15), R1, R2, and R3 represent independently a methylene group, or a substituted or non-substiruted phenylene group respectively, and k, m, and n are independently 0, 1, or 2 respectively.

Also, a copolymer with a structure in which the phosphorescent site and the carrier transporting site are incorporated into not side chains but a main chain is provided.

Substututed divalent group of thiophene, benzene, and fluorene and a divalent group of an iridium complex are polymerized to form a main chain as shown in

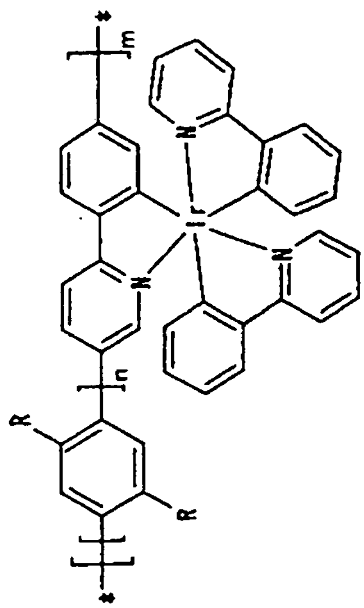

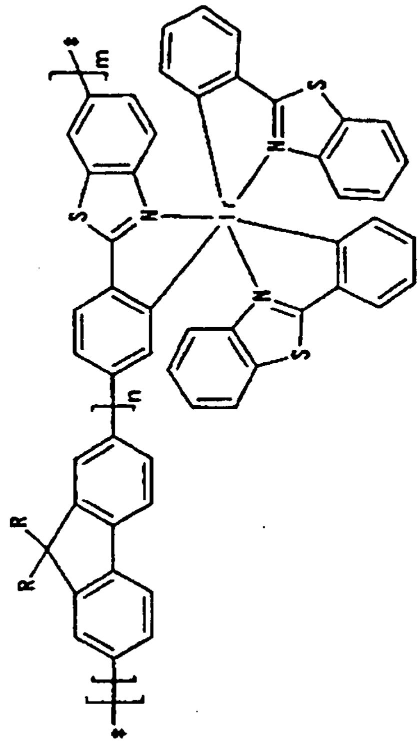

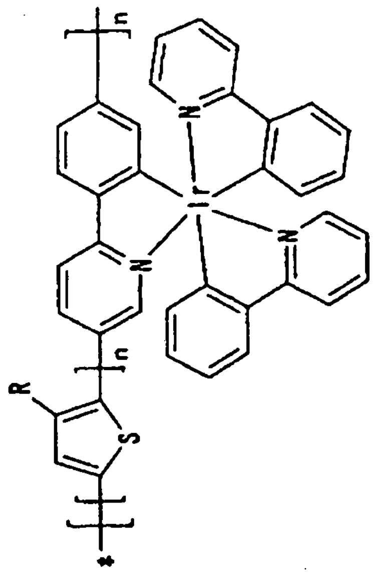

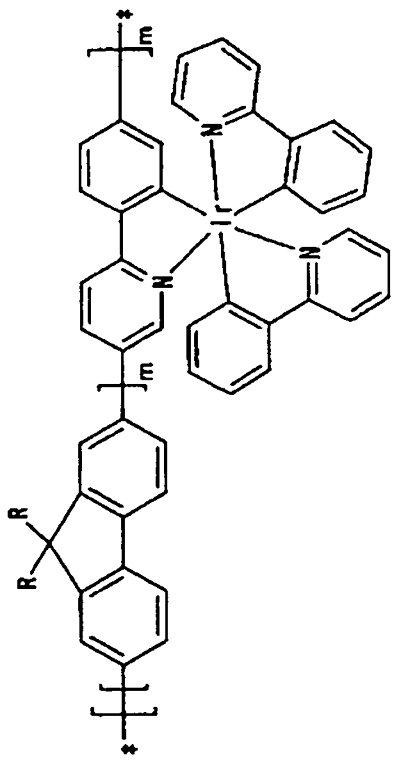

Thus, as examples of coplymers, although copolymers of either the hole transporting site or the electron transporting site and the phosphorescent site have been provided, the phosphorescent compound according to the present invention may be a copolymer of the hole transporting site, the electron transporting site, and the phosphorescent site. In this case, the hole transporting site, the electron transporting site, and the phosphorescent site may independently form a main chain of the copolymer and also may form side chains, respectively.

As the repeating number of the phosphorescent unit(s) is m and the repeating number of the carrier transporting unit(s) is n, in the present invention, in order to improve emission efficiency of phosphorescence, the relationship $m < n$, that is, the repeating number of the phosphorescent unit(s) being smaller than the repeating number of the carrier transporting unit(s), is desired. Hence, both of m and n are natural numbers of 1 or more. On the other hand, in the case of $m \geq n$, emission of the luminescence is suppressed by concentration quenching. Furthermore, in order to realize a very highly efficient emission of phosphorescence, it is preferable that the ratio of the repeating number of the phosphorescent unit(s) to the total number of the phosphorescent unit(s) and the carrier transporting unit(s) be equal to or less than 0.2. Also, as the ratio of the repeating number of the phosphorescent unit(s) is too small, the phosphorescent site(s) is/are reduced and the emission efficiency falls down. Thus, the ratio of the repeating number of the phosphorescent unit(s) has to be not too small, and is desired to be equal to or more than 0.0001. That is,

$$0.0001 \leq m/(m+n) \leq 0.2$$

is desired.

The phosphorescent compound according to the present invention may have one kind of phosphorescent unit radiating in one color and also may have two or more kinds of phosphorescent units radiating in two or more colors different from each other.

In the phosphorescent compound according to the present invention, by introducing two or more kinds of phosphorescent units radiating in two or more colors different from each other, a luminescent color that can not be obtained for a phosphorescent compound having only one kind of phosphorescent unit radiating in one color can be obtained.

For example, by introducing three kinds of phosphorescent units radiating in blue, green, and red respectively to one compound in an appropriate proportion, a phosphorescent compound for white luminescence can be obtained. Herein, the phosphorescent unit radiating in blue, green, or red is such that a luminescent color of photoluminescence shows blue, green, or red respectively in the case of forming one phosphorescent compound employing each one

independently or, furthermore, such that the luminescent color shows blue, green, or red respectively in the case of fabricating and lighting the organic light-emitting device mentioned below.

Furthermore, the blue color of the luminescent color mentioned herein is such that a peak wavelength in an emission spectrum is in 400 through 490 nm. Likewise, the green color is such that the peak wavelength is in 490 through 570 nm, and the red color is such that the peak wavelength is in 570 through 700 nm.

Also, the phosphorescent compound for white luminescence can be obtained by introducing two kinds of phosphorescent units radiating in blue or green and yellow or red respectively to one compound in appropriate proportion.

Furthermore, the blue color or the green color of the luminescent color mentioned herein is such that peak wavelength in an emission spectrum is in 400 through 570 nm, and likewise, the yellow color or the red color is such that the peak wavelength is in 570 through 700 nm.

Also, the phosphorescent material for white luminescence can be obtained not only as the single phosphorescent compound as described above but also as a composition in which a plurality of phosphorescent compounds having one or more phosphorescent units showing luminescent colors different from each other are compounded.

For example, a phosphorescent composition in which a first phosphorescent compound having two kinds of phosphorescent units that are a phosphorescent unit radiating in blue color and a phosphorescent unit in green color and a second phosphorescent compound having one kind of phosphorescent unit radiating in red color are compounded, a phosphorescent composition in which three phosphorescent compounds having each kind of the phosphorescent units radiating in blue, green, and red color, respectively are compounded, and a phosphorescent composition in which two phosphorescent compounds having each kind of the phosphorescent units radiating in blue and orange colors respectively are compounded, etc. can be given but any limitations are not provided to them.

It is desired that a film of the organic polymeric phosphorescent compound according to the present invention can be formed by a wet process. In the wet process, since a solution of the phosphorescent compound is provided, solubility in an organic solvent or water is needed. Particularly, in order to make the phosphorescent compound soluble in the organic solvent, it is desired to use a metal complex substituted with a relatively long carbon chain such as an alkyl group, or an alkoxy group, etc., as a phosphorescent site.

For the organic polymeric phosphorescent compound according to the present invention, it is desired that a degree of polymerization be in 5 through 5000. As the degree of the polymerization is less than 5, formation of a uniform film is difficult and crystallization is caused easily to reduce the stability. Also, an organic polymer of which a degree of polymerization is larger than 5000 is difficult to produce and is difficult to dissolve into an organic solvent. Therefore, as the degree of the polymerization is in 5 through 5000, a uniform and stable film can be formed.

Next, the organic light-emitting device according to the present invention will be illustrated.

For the organic light-emitting device according to the present invention, the organic polymeric phosphorescent compound according to the present invention described above can be employed as a luminescent material.

Also, for the organic light-emitting device according to the present invention, in order to further improve carrier transporting property of the phosphorescent compound according to the present invention, a composition in which the phosphorescent compound according to the present invention and the carrier transporting compound are compounded can be employed as a luminescent material.

That is, when the phosphorescent compound according to the present invention is a hole transporting one, an electron transporting compound can be admixed, and also when the phosphorescent compound according to the present invention is an electron transporting one, a hole transporting compound can be admixed. In these cases, the electron transporting compound and the hole transporting compound may be a low-molecular compound and also a polymer compound, respectively.

As the low-molecular hole transporting compound being compounded into the phosphorescent compound according to the present invention, a known hole transporting material represented by triphenylamine derivatives such as TPD (N,N'-diphenyl-N,N'-(3-methylphenyl)-1,1'-biphenyl-4,4'-diamine), $\alpha$-NPD (4,4'-bis[N-(1-naphtyl)-N-phenylamino]biphenyl), m-MTDATA (4,4',4''-tris(3-methylphenylphenylamino)triphenylamine), etc., and carbazole derivateives such as CBP (4,4'-N-N'-dicarbazole-biphenyl), etc. can be used but limitation is not provided to them.

Also, as the polymer hole transporting compound compounded into the phosphorescent compound according to the present invention, polyvinylcarbazole, and one provided by introduction of a polymerizable functional group to a triphenylamine-based low-molecular compound and polymerization, for example, the polymer compound with a triphenylamine skeleton disclosed in Japanese Laid-Open Patent Application No.8-157575 can be used but a limitation is not provided to them.

On the other hand, as the low-molecular electron transporting compound compounded into the phosphorescent compound according to the present invention, a quinolinol derivatives metal complex such as $Alq_3$ (trisaluminumquinolinol), etc., oxadiazole derivatives, triazole derivatives, imidazole derivatives, and triazine derivatives, etc. can be used but a limitation is not provided to them.

Also, as the polymer electron transporting compound compounded into the phosphorescent compound according to the present invention, one provided by introduction of a polymerizable functional group to the low-molecular

electron transporting compound described above, for example, polyPBD disclosed in Japanese Laid-Open Patent Application No. 10-1665 can be used but a limitation is not provided to them.

In addition, in order to further improve the physical properties, etc. of a film obtained by a film formation, a polymer compound not relating to the luminescence property is admixed into the phosphorescent compound or the phosphorescent composition according to the present invention to provide a composition, and this can also be employed as the luminescent material. For example, in order to give flexibility to the film, PMMA (polymethyl methacrylate) can be admixed, but a limitation is not provided to it.

The present invention also provides an organic light-emitting device characterized in that the organic polymer phosphorescent compound as described above is included in at least one layer. For the organic light-emitting device according to the present invention, since phosphorescent unit(s) and carrier transporting unit(s) of the phosphorescent compound are linked in a polymer chain, aggregation of the phosphorescent unit(s) of the phosphorescent compound caused by continuous running or overheating of the organic light-emitting device is suppressed to be able to provide a stable display apparatus, and since the phosphorescent, not fluorescent, unit is included, a very highly efficient emission can be realized.

Although, as shown in FIG. 2(a), the organic light-emitting device in which the phosphorescent compound according to the present invention is employed functions in a mono-layer structure such that the phosphorescent compound according to the present invention is interposed between an anode and a cathode in a pair, in order to improve the emission efficiency of phosphorescence, a laminated construction with an electron transporting layer in which an electron transporting polymer is employed, like FIG. 2(b) or a laminated construction with a hole transporting layer in which a hole transporting polymer is employed, like FIG. 2(c) are desired. As these carrier (electron and hole) transporting polymers, given are a polymer including a group of tertiary amines and derivatives thereof (HTP1,2), oxadiazole derivatives (ETP1,2), or imidazole derivatrives (ETP3), polyparaphenylenevinylene (CP1), and polydialkylfluorenes (CP2) such as

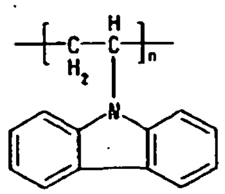

HTP1

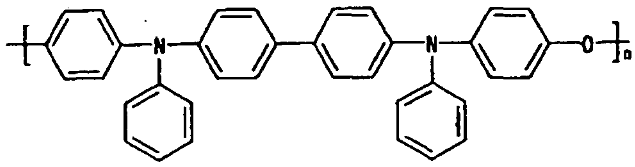

HTP2

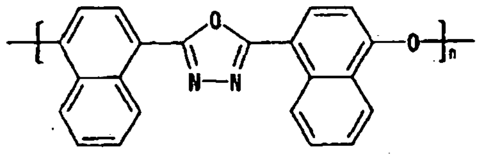

ETP1

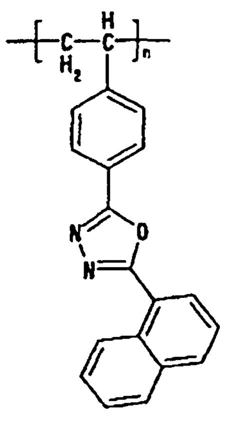

ETP2

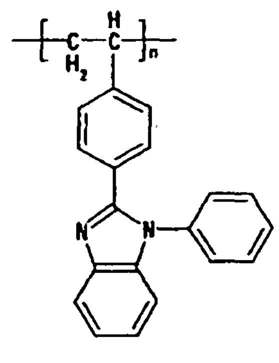

ETP3

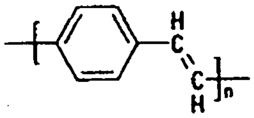

CP1

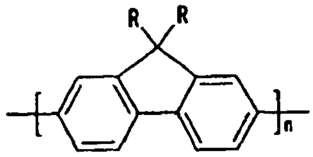

CP2

In the light-emitting device having the laminated construction of FIG. 2(b), the emission mechanism will be briefly explained for an organic light-emitting device in which the above-mentioned P1 polymer is employed as the phosphorescent compound and the polymer ETP2 including a group of oxadiazole derivatives is employed as the electron transporting polymer. Electrons injected from the cathode are transported through the electron transporting layer and injected into the phosphorescent compound P1 layer, while holes injected from the ITO anode conduct on repeat units including a carbazole ring of the phosphorescent compound P1. By the recombination of injected electrons with holes on the carbazole ring, an excited state of the repeat unit of the carbazole ring is created, and then energy transfers to the repeat unit of the iridium complex. As a result, a triplet excited state is created on the repeat unit of the iridium complex, and an emission of phosphorescence is observed because of energy relaxation. However, a mechanism such that recombination of the injected holes and electrons occurs on the repeat units of the iridium complex can be also considered.

The anode is generally formed on a glass substrate being a transparent substrate and an emission transmitting material is employed. ITO (indium tin oxide), indium oxide, tin oxide, or an indium oxide-zinc oxide alloy is preferable. A thin film of metal such as gold, platinum, silver, magnesium, etc. may be employed. Also, an electrically conductive polymer including polyaniline, polythiophen, polypyrrole, and derivatives thereof can be used.

For the cathode, it is preferable to employ an alkali metal such as Li, K, etc. and an alkali earth metal such as Mg, Ca, etc., of which work functions are small, from a viewpoint of electron injection efficiency. It is also desired to employ Al etc. that is chemically stable compared to these metals. In order to provide both the electron injection efficiency and chemical stability, a layer including two or more kinds of materials may be provided. Those materials are described in Japanese Laid-Open Patent Application No. 2-15595 and Japanese Laid-Open Patent Application No. 5-121172, etc. and a thin layer (approximately, 0.01 - 10 μm) of an alkali metal or an alkali earth metal such as cesium, calcium, strontium, barium, etc. may be interposed below the Al layer (suppose that the side of the cathode is the upper side and the side of the anode is the lower side).

The anode and the cathode can be formed by a publicly known method such as a vacuum evaporation method, a sputtering method, an ion plating method, etc. Also, it is preferable that a patterning for an electrode (particularly, an electrode of an emission transmitting material) be performed by a chemical etching such as photolithography, etc. and a physical etching utilizing a laser, etc. The patterning may be provided by superimposing a mask and performing vacuum evaporation or sputtering.

In the present invention, as a transparent substrate, a plastic substrate can be used besides the usual glass substrate. A plastic employed as a substrate is required to be excellent in respect to heat resistance, dimensional stability, solvent resistance, electrical insulation properties, processibility, low gas permeability, and low hygroscopicity. As such plastic, polyethylene terephthalate, polyethylene naphthalate, polystyrene, polycarbonate, polyethersulfone, polyallylate, and polyimide, etc. can be provided. A flexible organic light-emitting device can be provided by employing these flexible substrates. It is preferable that a moisture penetration preventing layer (gas barrier layer) be located on the surface of the substrate at the side of the electrode or the surface at the opposed side of the electrode, or the both surfaces. As the material for forming the moisture penetration preventing layer, inorganic materials such as silicon nitride and silicon oxide, etc. are preferred. A film of the moisture penetration preventing layer can be formed by highfrequency sputtering method, etc. Additionally, a hardcoat layer and an under-coat layer may be provided if necessary.

As a film formation method of a layer of an organic polymer such as the phosphorescent compound, the electron transporting polymer, and the hole transporting layer, etc., a spin-coating method from a solution is common, and besides it as the method capable of easily fabricating an organic polymeric layer with large surface area, a printing method, an ink-jet method, a spray method, and a dispenser method can be provided but a limitation is not be provided to them. Thus, in a display apparatus of which each pixel of a display screen includes the organic light-emitting device according to the present invention, an organic polymer can be applied separately for each of the pixels so that the display screen of the display apparatus can be made full color. Particularly for the ink-jet method, this separate application for each of the pixels and making the display screen full color can be performed easily.

In the display apparatus of which each pixel of the display screen includes the organic light-emitting device according to the present invention, due to arranging two or more transistors for each of the pixels and addressing and

driving the pixels by these transistors, a display apparatus with an active matrix system can be provided. One of at least two necessary transistors is a driving transistor for injecting an electrical current into an organic light-emitting device forming a pixel, and the other one is a switching transistor for controlling on/off for the electrical current injected into this driving transistor. Furthermore, as organic transistors are employed as these transistors, an application to a plastic substrate is allowed.

(Examples)

Examples of the phosphorescent compounds and synthesis methods thereof will be illustrated below. Examples 1-5 and 7 concern reference systems not according to the present invention and example 6 describes a phosphorescent compound according to the present invention. These examples are only illustrations for explanation and the present invention is not limited by these examples.

(Example 1-1) Synthesis of the monomer of the phosphorescent compound; [2-(3-methacrylphenyl)pyridine]bis[2-(3-propionylphenyl)pyridine]iridium(III) (simplified as Ir(MPPy)(PrCOPPy)$_2$ below)

First, 2-(3-methoxyphenyl)pyridine (MeOPPy) was synthesized according to the usual method of scheme (1).

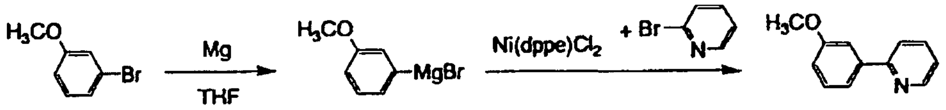


(1)

Specifically, 3-methoxyphenylmagnesiumbromide was synthesized from 8.98 g (48 mmol) of 3-bromoanisole using Mg in 60 ml of dried tetrahydrofuran (THF). Furthermore, the preceding obtained 3-methoxyphenylmagnesiumbromide was added into the solution in which 6.32 g (40 mmol) of 2-bromopyridine and 0.74 g of [1,2-bis(diphenylphosphino)ethane]dichloronickel(0) (Ni(dppe)Cl$_2$) had been dissolved into 40 ml of dried THF, and reaction was performed for 12 hours at room temperature to obtain 6.03 g (32.4 mmol) of colorless and transparent 2-(3-methoxyphenyl)pyridine (MeOPPy). Identification was performed by CHN elemental analysis, NMR, and IR.

Next, MeOPPy obtained in scheme (1) and tris(acetylacetonato)iridium(III) (Ir(acac)$_3$) were reacted at high temperature to synthesize tris(2-(3-methoxyphenyl)pyridine)iridium(III) (Ir(MeOPPy)$_3$) as shown in scheme (2).

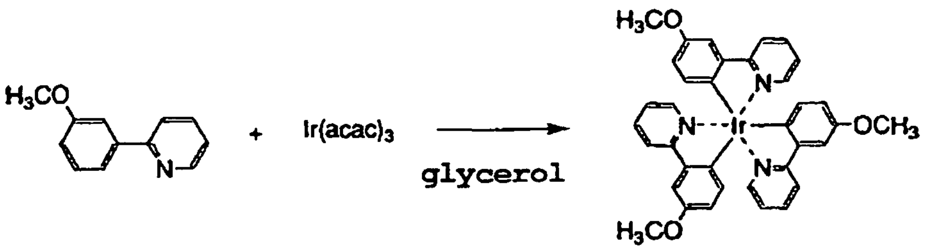


(2)

Specifically, 0.50 g (2.70 mmol) of MeOPPy and 0.20 g (0.41 mmol) of Ir(acac)$_3$ were reacted in 20ml of glycerol for 9 hours at 250 C° and purification was made in a column to obtain 0.020 g (0.027 mmol) of Ir(MeOPPy)$_3$ as fluorescent yellow powder. Identification was performed by CHN and Ir elemental analysis and IR.

MeO groups of Ir(MeOPPy)$_3$ obtained in scheme (2) were hydrolyzed to OH groups in hydrochloric acid aqueous solution to obtain powder of tris(2-(3-hydroxyphenyl)pyridine)iridium (III) (Ir(HOPPy)$_3$) according to the usual method of scheme (3).

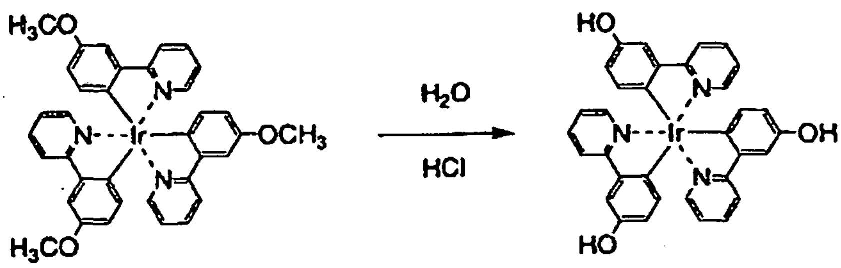


(3)

$Ir(HOPPy)_3$ obtained in scheme (3) was reacted with methacrylic acid chloride at molar ratio of 1:1 to perform methacrylation of a part of OH groups and to synthesize a complex based on Ir(Mppy) $(HOPPy)_2$ according to scheme (4). Then, the residual OH groups were reacted with propionic acid chloride (PrCOCl) to obtain a complex based on $Ir(MPPy)(PrCOPPy)_2$.

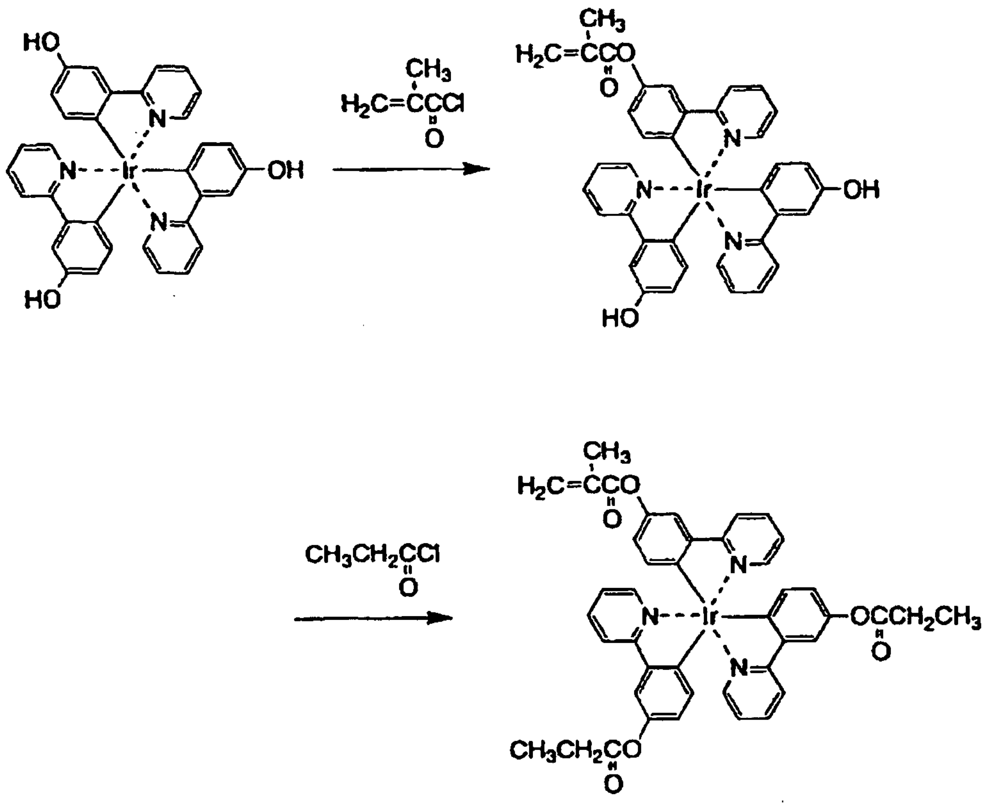

(4)

Specifically, after 8 ml of dried THF, 0.706 g (1 mmol) of $Ir(HOPPy)_3$ and 0.600 g (5.9 mmol) of triethylamine were put into a reactor, a solution in which 0.106 g (1 mmol) of methacrylic acid chloride was dissolved into 4 ml of dried THF was dropped for 30 minutes and reaction was performed for 5 hours at 20 °C. A solution in which 0.370 g (4 mmol) of propionic acid chloride was dissolved into 4ml of dried THF was further dropped into this reacted solution for 30 minutes and reaction was performed for 5 hours at 20 °C so that the residual OH groups was reacted, and a hydrochloride of triethylamine was filtered and separated. The solvent in the filtrate was evaporated and exsiccated and the obtained solid content was purified by performing recrystallization in chloroform / methanol-mixed solvent twice, to obtain 0.523 g (0.59 mmol) of objective $Ir(MPPy)(PrCOPPy)_2$ as powder. Identification for this complex was performed by CHN and Ir elemental analysis and IR.

(Example 1-2) Synthesis of the phosphorescent compound; [2-(3-methacrylphenyl)pyridine]bis[2-(3-propionylphenyl)pyridine]iridium(III) / N-vinylcarbazole copolymer (simplified as Ir(Mppy)·$(PrCOPPy)_2$ / VCz copolymer below)

According to scheme (5), after 0.222 g (0.25 mmol) of Ir(MPPy) $(PrCOPPy)_2$ complex synthesized in example 1, 0.918 g (4.75 mmol) of N-vinylcarbazole (VCz) (Ir(MPPy) $(PrCOPPy)_2$ and VCz being in molar ratio of 5:95), 0.010 g (0.061 mmol) of 2,2'-azobis(isobutyronitrile)(AIBN), 10 ml of butyl acetate were put into a reactor and replacement with nitrogen was performed, reaction was performed for 10 hours at 80 °C.

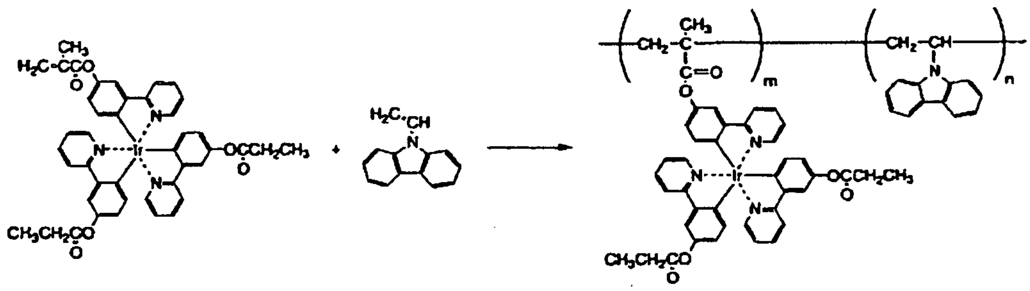

(5)

After the reaction, the product was thrown into acetone, reprecipitation was performed, and a copolymer was recovered by filtration. Throwing of a solution of the recovered copolymer in chloroform into methanol for reprecipitation was further performed twice for purification and vacuum drying was performed after recovering the precipitation, to obtain 0.946 g of objective Ir(MPPy)(PrCOPPy)$_2$ / VCz copolymer as powder. CHN and Ir elemental analysis for the obtained copolymer supported that Ir(MPPy) (PrCOPPy)$_2$ and VCz copolymerized in molar ratio of 5:95. That is, the repeating number m of the phosphorescent units / the repeating number of the carrier transporting units n = 5 / 95 is considered. Also, from GPC for the copolymer in chloroform, weight-average molecular weight was 12000 relative to the polystyrene standard (an average degree of polymerizaion calculated from the weight-average molecular weight being 37). Furthermore, the phosphorescent compound according to the present invention is soluble in an organic solvent such as chloroform, etc.

(Example 1-3) Fabrication of an organic light-emitting device

A solution of Ir(MPPy) (PrCOPPy)$_2$ / VCz copolymer and an oxadiazole derivative (tBu-PBD) being an electron transporting material in chloroform was prepared. The proportion was 65 percent by weight for Ir(MPPy) (PrCOPPy)$_2$ / VCz copolymer to 35 percent by weight for tBu-PBD. This solution was spin-coated on a glass substrate with indium tin oxide (ITO) being a transparent electrode to form a film with the thickness of 100 nm, and 10 nm of Ca and 100 nm of Al were deposited on it by a vacuum evaporation to provide a cathode. As a positive electrical voltage was applied on the ITO-side of this organic light-emitting device and a negative electrical voltage was applied on the Al-side, green luminescence originating from the iridium complex was observed. The quantum yield of the luminescence was approximately 4%.

(Example 2-1) Synthesis of the monomer of the phosphorescent compound; {2-[3-(2-methacryloyloxyethyl)carbamoyloxyphenyl]pyridine)bis[2-(3-propionylphenyl)pyridine]iridium(III) (simplified as Ir(MiPPy)(PrCOPPy)$_2$ below)

The intermediate of the monomer Ir(HOPPy)$_3$ synthesized in the example 1-1 was reacted with methacryloyl oxyethylisocyanate (MOI, produced by Showa Denko K. K.) at 1:1, and subsequently the residual OH group was reacted with PrCOCl to obtain a complex based on Ir(MiPPy)(PrCOPPy)$_2$,as shown in scheme (6).

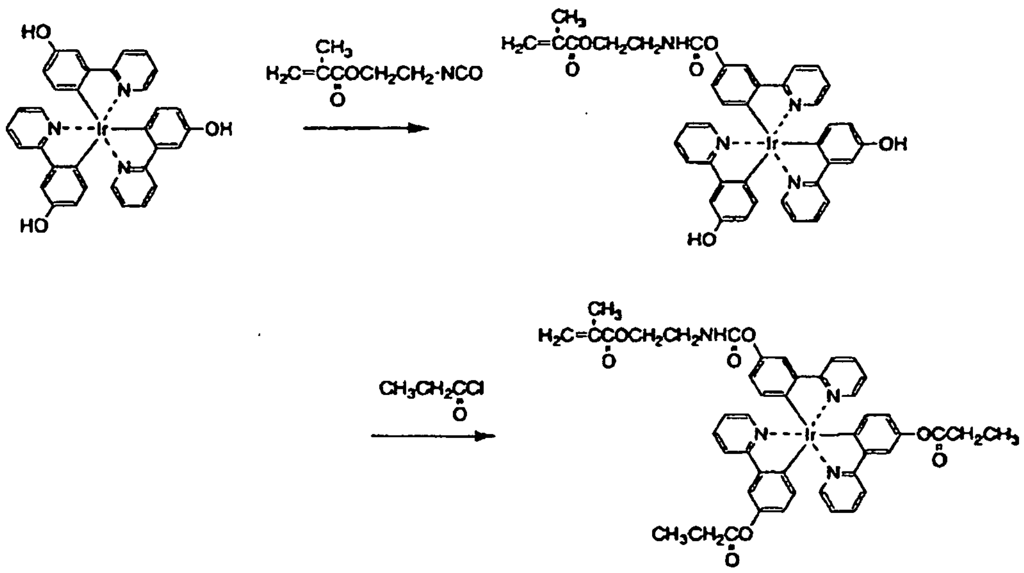


(6)

Specifically, 8 ml of dried THF, 0.706 g (1 mmol) of $Ir(HOPPy)_3$, and 0.106 g (1 mmol) of MOI were put into a reactor and reaction was performed for 5 hours at 20 °C. After 0.600 g (5.9 mmol) of triethylamine as a deoxidizer was added into this reacted solution, a solution in which 0.370 g (4 mmol) of propionylchloride was dissolved into 4 ml of dried THF was dropped for 30 minutes and, furthermore, reaction was performed for 5 hours at 20 °C so that the residual OH groups was reacted, and hydrochloride of triethylamine was filtered and separated. The solvent in the filtrate was evaporated and exsiccated and the obtained solid content was purified by performing recrystallization in chloroform / methanol-mixed solvent twice, to obtain 0.613 g (0.63 mmol) of objective $Ir(MiPPy)(PrCOPPy)_2$ as powder. Identification for it was performed by CHN and Ir elemental analysis and IR.

(Example 2-2) Synthesis of the phosphorescent compound; {2-[3-(2-methacryloyloxyethyl)carbamoyloxyphenyl]pyridine}bis[2-(3-propionylphenyl)pyridine]iridium(III) / N-vinylcarbazole copolymer (simplified as $Ir(MiPPy) (PrCOPPy)_2$ / VCz copolymer below)

According to scheme (7), after 0.243 g (0.25 mmol) of $Ir(MiPPy) (PrCOPPy)_2$ complex synthesized in example 3, 0.918 g (4.75 mmol) of N-vinylcarbazole (VCz) ($Ir(MiPPy) (PrCOPPy)_2$ and VCz being in molar ratio of 5:95), 0.010 g (0.061 mmol) of 2,2'-azobis(isobutyronitrile)(AIBN), 10 ml of butyl acetate were put into a reactor and replacement with nitrogen was performed, reaction was performed for 10 hours at 80 °C.

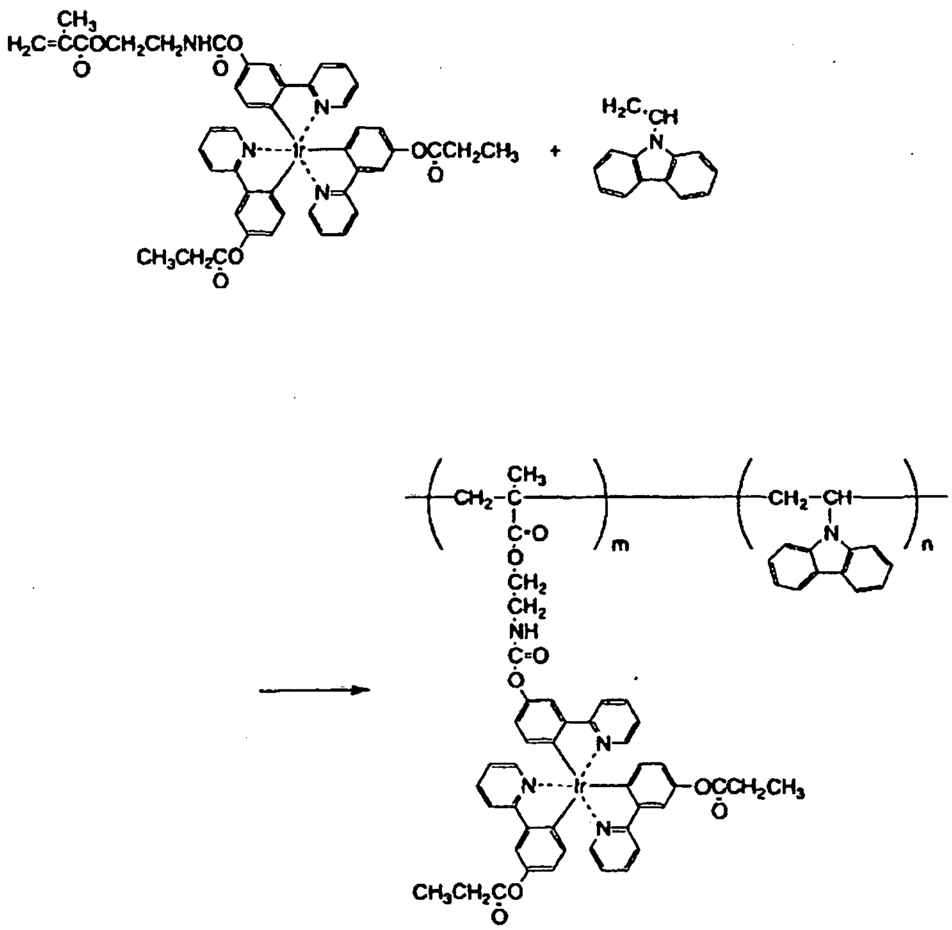

(7)

After the reaction, throwing into acetone for reprecipitation was performed and a copolymer was recovered by filtration. Throwing of a solution of the recovered copolymer in chloroform into methanol for reprecipitation was further performed twice for purification and vacuum drying was performed after recovering the precipitation, to obtain 1.053 g of objective Ir(MiPPy) $(PrCOPPy)_2$ / VCz copolymer as powder. CHN and Ir elemental analysis for the obtained copolymer supported that Ir(MiPPy) $(PrCOPPy)_2$ and VCz copolymerized in molar ratio of 5:95. That is, the repeating number m of the phosphorescent units / the repeating number of the carrier transporting units n = 5 / 95 is considered. Also, from GPC for the copolymer in chloroform, weight-average molecular weight was 23000 relative to the polystyrene standard (an average degree of polymerizaion calculated from the weight-average molecular weight being 64). Furthermore, the phosphorescent compound according to the present invention is soluble in an organic solvent such as chloroform, etc.

(Example 2-3) Fabrication of an organic light-emitting device

A solution of Ir (MiPPy) $(PrCOPPy)_2$ / VCz copolymer and tBu-PBD in chloroform was prepared. The proportion was 65 percent by weight for Ir(MiPPy)$(PrCOPPy)_2$ / VCz copolymer to 35 percent by weight for tBu-PBD. This solution was spin-coated on a glass substrate with ITO to form a film with the thickness of 100 nm, and 10 nm of Ca and 100 nm of Al were deposited on it by a vacuum evaporation to provide a cathode. As a positive electrical voltage was applied on the ITO-side of this organic light-emitting device and a negative electrical voltage was applied on the Al-side, green luminescence originating from the iridium complex was observed. The quantum yield of the luminescence was approximately 3 %.

(Example 3-1) Synthesis of the phosphorescent compound; [2-(3-hexylphenyl)pyridine]bis(2-phenylpyridine)iridium(III) / 3-hexylthiophene copolymer (simplified as Ir(HPPy)$PPy_2$ / HT copolymer below)

As shown in scheme (8), 0.099 g (0.25 mmol) of 5-bromo-2-(4-bromo-3-hexylphenyl)pyridine ($HPPyBr_2$) and 1.549g (4.75mmol) of 3-hexyl-2,5-dibromothiophene ($HTBr_2$) (($HPPyBr_2$) and ($HTBr_2$) being in molar ratio of 5:95) were copolymerized with $Ni(COD)_2(O)$ catalyst (wherein COD represents a cyclooctadienyl group) in 10 ml of dimethylformamide (DMF) to synthesize 2-(3-hexylphenyl)pyridine / 3-hexylthiophene copolymer (HPPy / HT copolymer) according to

the usual method. Then, 0.625 g (4 mmol) of this HPPy / HT copolymer and 0.099 g (0.2 mmol) of $Ir(acac)_3$ were dissolved in metacresol and reaction was performed for 10 hours at 250 °C. Furthermore, 0.062 g (0.4 mmol) of phenylpyridine was added into this solution and reaction was performed for 10 hours at 250 °C.

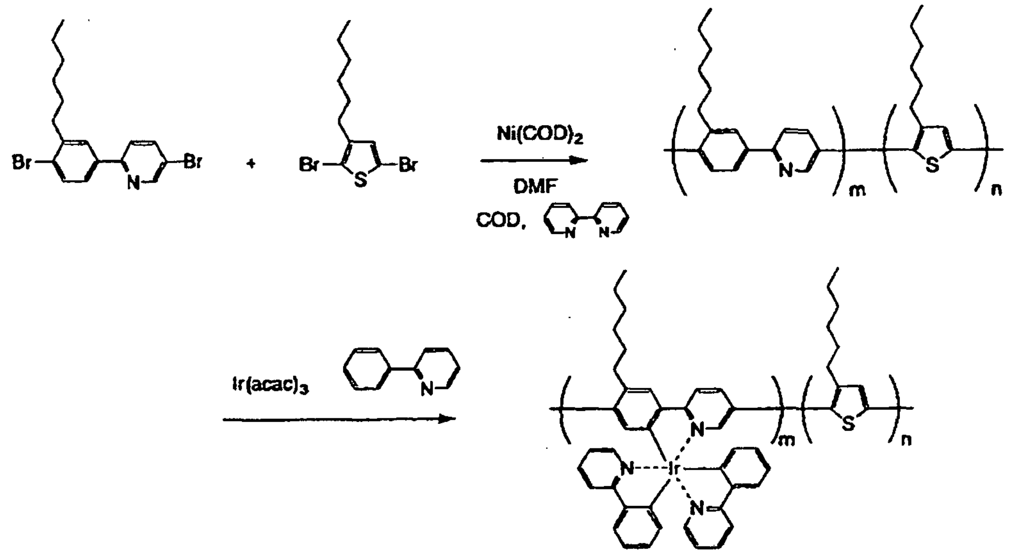


(8)

After the reaction, throwing into acetone for reprecipitation was performed and a copolymer was recovered by filtration. Throwing of a solution of the recovered copolymer in DMF into acetone for reprecipitation was further performed twice for purification and vacuum drying was performed after recovering the precipitation, to obtain 0.564 g of objective $Ir(HPPy)PPy_2$ / HT copolymer as powder.

CHN and Ir elemental analysis for the copolymer supported a supposed structure. That is, the repeating number m of the phosphorescent units / the repeating number of the carrier transporting units n = 5 / 95 is considered. Also, from GPC for the copolymer in hexafluoroisopropanol, weight-average molecular weight was 18000 relative to the polystyrene standard (an average degree of polymerizaion calculated from the weight-average molecular weight being 68). Furthermore, the phosphorescent compound according to the present invention is soluble in an organic solvent such as DMF, etc.

(Example 3-2) Fabrication of an organic light-emitting device

A solution of $Ir(HPPy)PPy_2$ / HT copolymer and tBu-PBD in chloroform was prepared. The proportion was 65 percent by weight for $Ir(HPPy)PPy_2$ / HT copolymer to 35 percent by weight for tBu-PBD. This solution was spin-coated on a glass substrate with ITO to form a film with the thickness of 100 nm, and 10 nm of Ca and 100 nm of Al were deposited on it by a vacuum evaporation to provide a cathode. As a positive electrical voltage was applied on the ITO-side of this organic light-emitting device and a negative electrical voltage was applied on the Al-side, yellow luminescence originating from the iridium complex was observed. The quantum yield of the luminescence was approximately 1 %.

(Example 4-1) Synthesis of the monomer of the electron transporting compound; 2-(4-tert-butyl-phenyl)-(4'-vinyl-biphenyl-4-yl)-[1,3,4]oxadiazole (simplified as VPBD below)

VPBD was synthesized according to the method disclosed in Japanese Laid-Open Patent Application No. 10-1665.

(Example 4-2) Synthesis of the phosphorescent compound; [2-(3-methacrylphenyl)pyridine]bis[2-(3-propionylphenyl)pyridine]iridium(III) / N-vinylcarbazole / 2-(4-tert-butyl-phenyl)-5-(4'-vinyl-biphenyl-4-yl)-[1,3,4]oxadiazole copolymer (simplified as $Ir(MPPy)(PrCOPPy)_2$ / VCz / VPBD copolymer below)

According to scheme (9), after 0.222 g (0.25 mmol) of Ir(MPPy) $(PrCOPPy)_2$ complex synthesized in example 1-1, 0.628 g (3.25 mmol) of VCz, 0.571 g (1.50 mmol) of VPBD synthesized in example 4-1 described above (the molar ratio being Ir(MPPy) $(PrCOPPy)_2$ : VCz : VPBD = 5 : 65 : 30), 0.010 g (0.061 mmol) of 2,2'-azobis(isobutyronitrile) (AIBN), and 10 ml of benzene were put into a reactor and replacement with nitrogen was performed, reaction was performed for 10 hours at 80°C.

After the reaction, the product was thrown into acetone, reprecipitation was performed, and a copolymer was recovered by filtration. Throwing of a solution of the recovered copolymer in chloroform into methanol for reprecipitation was further performed twice for purification and vacuum drying was performed after recovering the precipitation, to obtain 0.80 g of objective Ir(MPPy) $(PrCOPPy)_2$ / VCz / VPBD copolymer as powder.

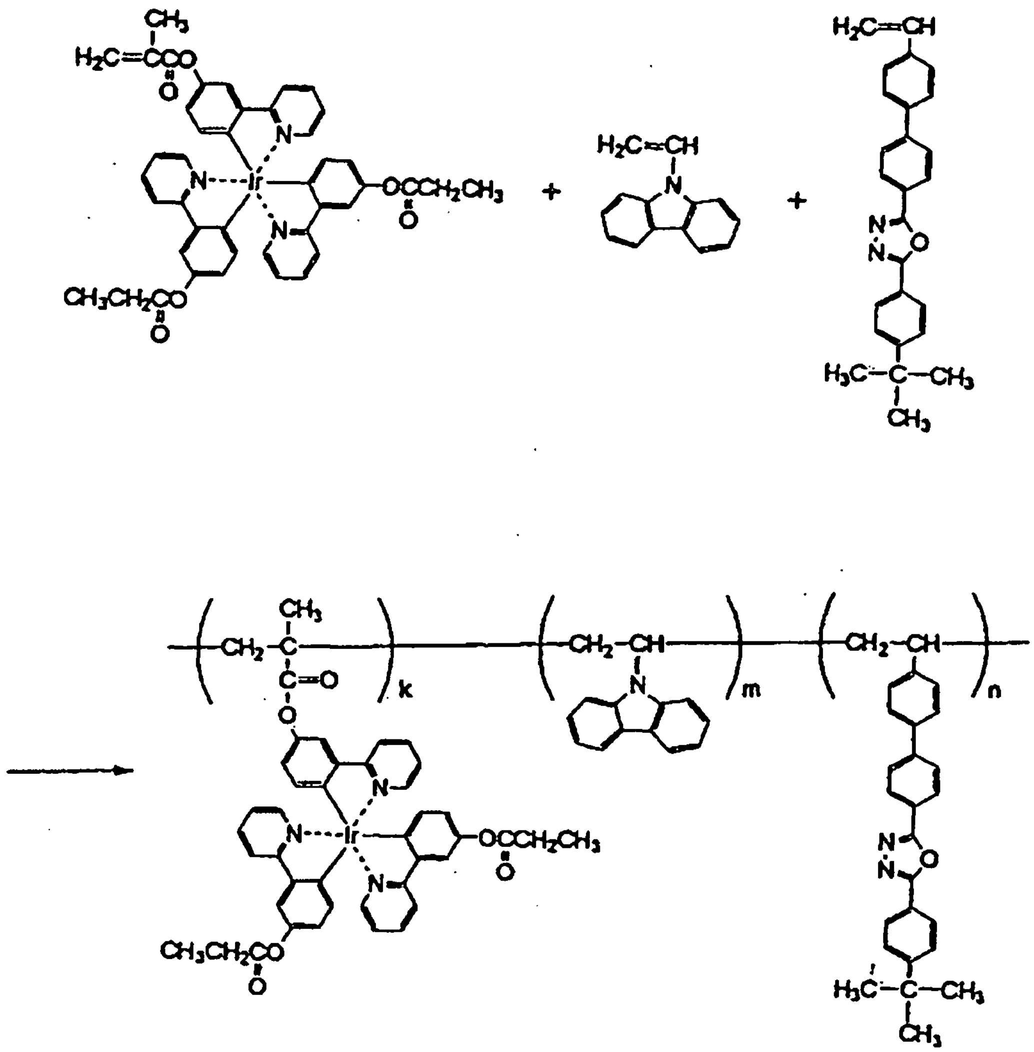

(9)

CHN and Ir elemental analysis for the obtained copolymer (phosphorescent compound) supported that copolymerization was made in the molar ratio of Ir(MPPy)$(PrCOPPy)_2$ : VCz : VPBD = 5 : 65 : 25. That is, (the repeating number of the phosphorescent units : k) / (the repeating number of the carrier transporting units m+n) = 5 / 90 is considered. Also, from GPC for the copolymer in chloroform, weight-average molecular weight of the copolymer was 30000 relative to the polystyrene standard (an average degree of polymerizaion calculated from the weight-average molecular weight being 107). This copolymer is soluble in an organic solvent such as chloroform, etc.

(Example 4-3) Fabrication of an organic light-emitting device

A solution of Ir(MPPy)$(PrCOPPy)_2$ / VCz / VPBD copolymer obtained in example 4-2 in chloroform was prepared. This solution was spin-coated on a glass substrate with ITO to form a film with the thickness of 100 nm, and 10 nm of Ca and 100 nm of Al were deposited on it by a vacuum evaporation to provide a cathode so that an organic light-emitting device was obtained. As a positive electrical voltage was applied on the ITO-side of this organic light-emitting device and a negative electrical voltage was applied on the Al-side, green luminescence originating from the iridium complex was observed. The quantum yield of the luminescence was approximately 3 %.

(Example 5-1) Synthesis of the electron transporting polymer compound; poly-VPBD (simplified as PVPBD below)

PVPBD was synthesized according to the method disclosed in Japanese Laid-Open Patent Application No. 10-1665.

(Example 5-2) Fabrication of an organic light-emitting device

A solution of Ir(MPPy)(PrCOPPy)$_2$ / VCz copolymer obtained in example 1-2 and PVPBD obtained in example 5-1 in chloroform was prepared. The proportion was 65 percent by weight for Ir(MPPy) (PrCOPPy)$_2$ / VCz copolymer to 35 percent by weight for PVPBD. This solution was spin-coated on a glass substrate with indium tin oxide (ITO) being a transparent electrode to form a film with the thickness of 100 nm, and 10 nm of Ca and 100 nm of Al were deposited on it by a vacuum evaporation to provide a cathode so that an organic light-emitting device was obatined. As an electrical voltage.was applied wherein the ITO-side of this organic light-emitting device was at positive and the Al-side was at negative, green luminescence originating from the iridium complex was observed. The quantum yield of the luminescence was approximately 4.5 %.

(Example 6-1) Synthesis of the monomer having a blue phosphorescent site; iridium(III) bis(2-(2,4-difluorophenyl)pyridinato) (5-methacryloyloxymethylpicolinato) (simplified as Ir(2,4-F-ppy)$_2$(5-CH$_2$MA-pic) below)

As shown in scheme (10), iridium(III) bis(2-(2,4-difluorophenyl)pyridinato)(5-(hydroxymethyl)picolinato) (simplified as Ir(2,4-F-ppy)$_2$(5-CH$_2$OH-pic) below) was synthesized. That is, 10 ml of dried N,N-dimethylformamide was added to 121.6 mg (0.1 mmol) of [Ir(2,4-F-ppy)$_2$Cl]$_2$, 45.9 mg (0.3 mmol) of 5-hydroxymethylpicolinic acid, 106.0 mg (1.0 mmol) of sodium carbonate under argon gas stream and steering was performed for 2 hours at 80 °C. After 50ml of water was added into the reacted liquid, extraction with ethyl acetate was performed. After the solution was dried over magnesium sulfate, concentrated, and purified by means of column chromatography (silica gel, methanol : chloroform = 1 : 19 (volume ratio)). Furthermore, it was recrystallized from hexane / chloroform to obtain 108.7 mg of Ir(2,4-F-ppy)$_2$(5-CH$_2$OH-pic as a yellow crystal. Yield: 75%. Identification was performed by $^1$H-NMR and CHN elemental analysis. $^1$H-NMR (270 MHz, DMSO-d$_6$), ppm: 8.54(d, 1H, J = 4.6), 8. 3 - 8.2(m, 2H), 8.1 - 8.0(m, 4H), 7.70(s, 1H), 7.61(d, 1H, J = 4.9), 7.49(dd, 1H, J = 6.6, .6.6), 7.32(dd, 1H, J = 6.6, .6.6), 6.9 - 6.7(m, 2H), 5.71(dd, 1H, J = 8.9, 2.4), 5.46(dd, 1H, J = 8.5, 2.3), 5.42(t, 1H, J = 4.6), 4.49(d, 2H, J = 4.6). Anal. Found: C 48.05, H 2.54, N 5.86. Calcd: C 48.06, H 2.50, N 5.80.

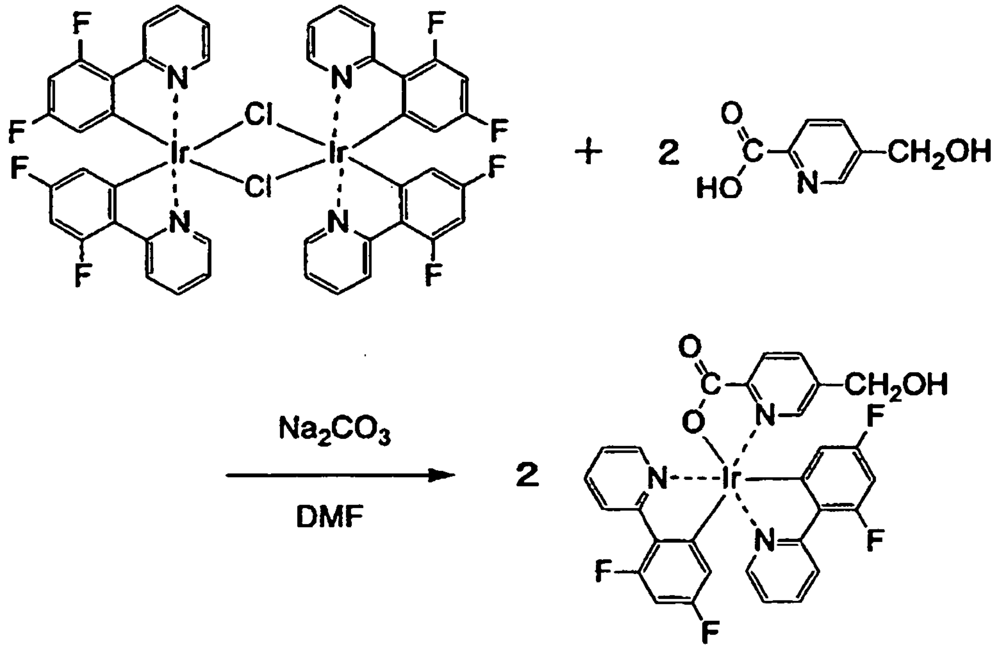


(10)

Subsequently, As shown in scheme (11), Ir(2,4-F-ppy)$_2$(5-CH$_2$MA-pic) was synthesized. That is, 72.5 mg (0.1 mmol) of Ir(2,4-F-ppy)$_2$(5-CH$_2$OH-pic) and 0.2 mg of 2,6-di-tert-4-methylphenol were dissolved into 10 ml of dried dichloromethane under argon gas stream, 101.2 mg (1.0 mmol) of triethylamine and 52.3 mg (0.5 mmol) of methacrylic acid chloride were added, and steering was performed for 2 hours at room temperature. 50 ml of water was added into the reacted liquid and extraction with chloroform was performed. After the solution was dried over magnesium sulfate,

concentrated, and purified by means of column chromatography (silica gel, methanol : chloroform = 3 : 97 (volume ratio)). Furthermore, it was recrystallized from hexane / chloroform to obtain 70.6 mg of Ir(2,4-F-ppy)$_2$(5-CH$_2$MA-pic) as a yellow crystal. Yield: 89 %. Identification was performed by $^1$H-NMR and CHN elemental analysis. $^1$H-NMR(270 MHz, DMSO-d$_6$), ppm: 8.53(d, 1H, J = 5.1), 8.28(d, 1H, J = 8.4), 8.22(d, 1H, J = 8.6), 8.1 - 8.0(m, 4H), 7.70(s, 1H), 7.66(d, 1H, J = 4.9), 7.48(dd, 1H, J = 6.5, .6.5), 7.31(dd, 1H, J = 6.5, .6.5), 6.9 - 6.7(m, 2H), 5.84(s, 1H), 5.7 - 5.6(m, 2H), 5.47(dd, 1H, J = 8.8, 2.6), 5.24 (d, 2H, J = 2.7), 1. 78 (s, 3H). Anal. Found: C 49.92, H 2.87, N 5.28. Calcd: C 50.00, H 2.80, N 5.30.

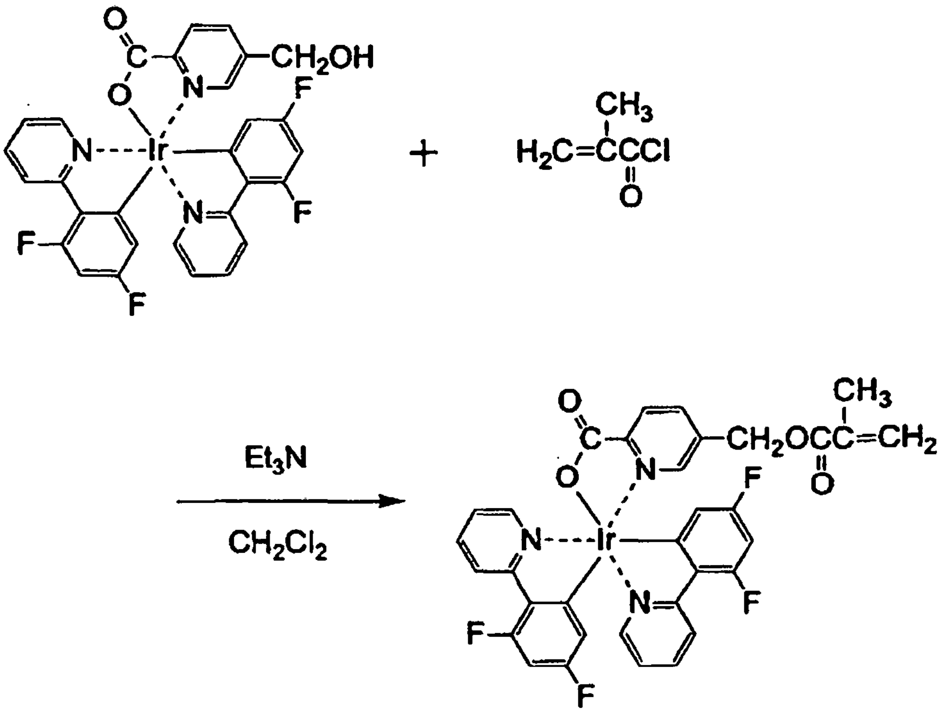


(11)

(Example 6-2) Synthesis of the monomer having a green phosphorescent site; [6-(4-vinylphenyl)-2,4-hexanedionato]bis(2-phenylpyridine) iridium(III) (simplified as Ir(ppy)$_2$[1-(StMe)-acac] below)

As shown in scheme (12), acetylacetone and 4-vinylbenzylchloride were reacted to synthesize 6-(4-vinylphenyl)-2,4-hexanedione. That is, 1.23 g (60% in oil) (31 mmol) of sodium hydride was weighed under nitrogen atmosphere, 60 ml of dried tetrahydrofuran (simplified as THF below) was added to it, and cooling was performed to 0 °C in an ice bath. As the mixed solution of 2.5 g (24 mmol) of acetylacetone and 1 ml of hexamethylphospholic triamide was dropped into this suspension, colorless precipitation was produced. After steering for 10 minutes at 0 °C, as 17.5 ml (28 mmol) of a solution (1.6 M) of n-butyl lithium in hexane was dropped, the precipitate was dissolved, and steering was further performed for 20 minutes at 0 °C. 4.0 g (26 mmol) of 4-vinylbenzylchloride was dropped into the obtained pale yellow solution, and after the reacted liquid was returned to room temperature and steered for 20 minutes, diluted hydrochloric acid was added so as to render the water phase acidic. After the organic phase was washed with saturated sodium chloride aqueous solution and dried over magnesium sulfate, the solvent was evaporated by a rotary evaporator. The obtained reaction mixture was added into a silica gel column and developed with a mixed solvent of 1:1 (volume ratio) hexane / dichloromethane to fractionate a main product. The solvent was evaporated from the obtained solution under reduced pressure to obtain 3.0g (14mmol) of objective 6-(4-vinylphenyl)-2,4-hexanedione as brown liquid. Yield: 56 %. Identification was performed by CHN elemental analysis and $^1$H-NMR. $^1$H-NMR (CDCl$_3$): enol; $\delta$ 7.33 (d, J = 8.1 Hz, 2 H, aromatic), 7.14 (d, J = 8.4 Hz, 2 H, aromatic), 6.68 (dd, J = 8.1 Hz, 1 H, vinylic), 5.70 (d, J = 17.0 Hz, 1 H, vinylic), 5.46 (s, 1 H, diketonate-methine), 5.20 (d, J = 11.1 Hz, 1 H, vinylic), 2.91 (t, J = 5.7 Hz, 2 H, methylene), 2.58 (t, J = 7.3 Hz, 2 H, methylene), 2.03 (s, 3 H, methyl). keto; $\delta$ 7.33 (d, J = 8.1 Hz, 2 H, aromatic), 7.14 (d, J = 8.4 Hz, 2 H, aromatic), 6.68 (dd, J = 8.1 Hz, 1 H, vinylic), 5.70 (d, J = 17.0 Hz, 1 H, vinylic), 5.20 (d, J = 11.1 Hz, 1 H, vinylic), 3.53 (s, 2 H, C(=O)CH$_2$C(=O)), 2.89 (m, 4 H, ethylene), 2.19 (s, 3 H, methyl). enol : keto = 6 : 1. E.A.: Calcd for C$_{14}$H$_9$O$_2$ : C, 77.75; H, 7.46. Found: C, 77.49; H, 7.52.

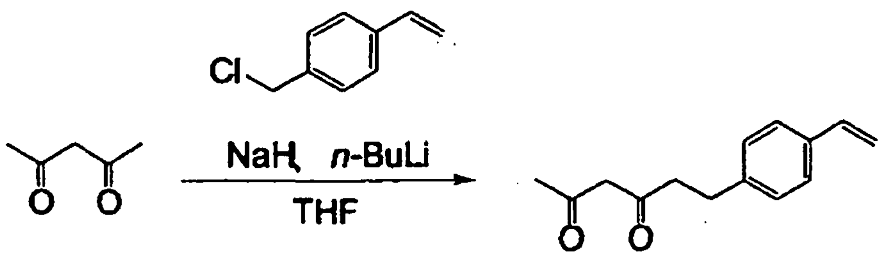


(12)

Subsequently, as shown in scheme (13), this 6-(4-vinylphenyl)-2,4-hexanedione and $[Ir(ppy)_2Cl]_2$ synthesized according to a usual method were reacted to synthesize $Ir(ppy)_2$[1-(StMe)-acac]. That is, 342 mg (0.32 mmol) of $[Ir(ppy)_2Cl]_2$, 1.58 mg (1.5 mmol) of sodium carbonate, and 5 mg (0.023 mmol) of 2,6-di-tert-butyl-4-methylphenol were dissolved into 5 ml of N,N-dimethylformamide (simplified as DMF below), 210 mg (0.97 mmol) of 6-(4-vinylphenyl)-2,4-hexanedione was added into it, and steering with heating was performed for 1 hour at 65 °C. Then, after diluted hydrochloric acid aqueous solution was added to the reacted solution cooled to room temperature, a pale yellow component was extracted with chloroform. After the solvent was evaporated using a rotary evaporator, the residue was dissolved into a small amount of dichloromethane to fractionate a yellow main product by means of silica gel column chromatography (developer: dichloromethane). This solution was exsiccated under reduced pressure, a dichloromethane-hexane mixed solution was added, and recrystallization was performed at -20 °C, to obtain 354 mg (0.49 mmol) of objective $Ir(ppy)_2$[1-(St-Me)-acac] as a pale yellow crystal. Yield: 78 %. Identification was performed by CHN elemental analysis and $^1$H-NMR. $^1$H NMR ($CDCl_3$): $\delta$ 8.47 (d, J = 5.7 Hz, 1 H, ppy), 8.21 (d, J = 5.7 Hz, 1 H, ppy), 7.9 - 7.5 (m, 6 H, ppy), 7.18 (d, J = 8.1 Hz, 2 H, stylyl-aromatic), 7.00 (m, 2 H, ppy), 6.89 (d, J = 8.1 Hz, 2 H, stylyl-aromatic), 6.75 (m, 5 H, ppy and vinylic), 6.28 (t, J = 7.3 Hz, 2 H, ppy), 7.67 (d, J = 17.6 Hz, 1 H, vinylic), 5.19 (d, J = 9.5 Hz, 1 H, vinylic), 5.17 (s, 1 H, diketonate-methine), 2.60 (t, J = 7.3 Hz, 2 H, ethylene), 2.36 (m, 2 H, ethylene), 1.75 (s, 3 H, methyl). E.A.: Calcd for $C_{36}H_{31}IrN_2O_2$: C, 60.40; H, 4.36; N, 3.91.
Found: C, 61.35; H, 4.34; N, 3.83.

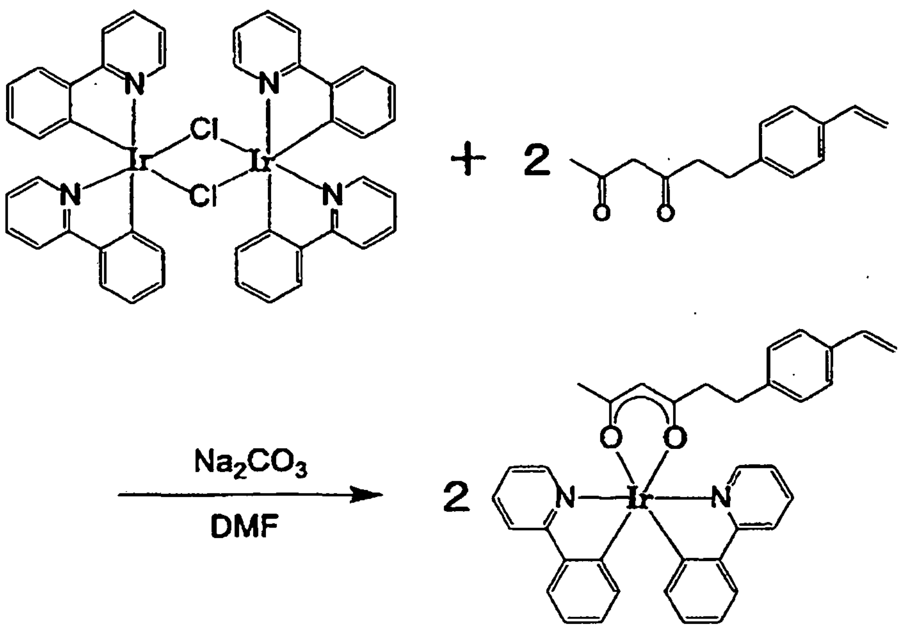


(13)

(Example 6-3) Synthesis of the monomer having a red phosphorescent site; [6-(4-vinylphenyl)-2,4-hexanedionato]bis[2-(2-pyridyl)benzothienyl] iridium(III) {simplified as $Ir(btp)_{21}$[-(StMe)-acac] below}

As shown in scheme (14), acetylacetone and 4-vinylbenzylchloride were reacted to synthesize 6-(4-vinylphenyl)-2,4-hexanedione. That is, 1.23 g (60 % in oil) (31 mmol) of sodium hydride was weighed under nitrogen atmosphere, 60 ml of dried tetrahydrofuran (simplified as THF below) was added to it, and cooling was performed to 0 °C in an ice bath. As the mixed solution of 2.5 g (24 mmol) of acetylacetone and 1 ml of hexamethylphospholic triamide (simplified as HMPA below) was dropped into this suspension, colorless precipitation was produced. After steering for 10 minutes at 0 °C, as 17.5 ml (28 mol) of a solution (1.6 M) of n-butyl lithium in hexane was dropped, the precipitate was dissolved,

and steering was further performed for 20 minutes at 0 °C. 4.0 g (26 mmol) of 4-vinylbenzylchloride was dropped into the obtained pale yellow solution, and after the reacted liquid was returned to room temperature and steered for 20 minutes, diluted hydrochloric acid was added so as to render the water phase acidic. After the organic phase was washed with saturated sodium chloride aqueous solution and dried over magnesium sulfate, the solvent was evaporated by a rotary evaporator. The obtained reaction mixture was added into a silica gel column and developed with a mixed solvent of 1:1 (volume ratio) hexane / dichloromethane to fractionate a main product. The solvent was evaporated from the obtained solution under reduced pressure to obtain 3.0 g (14 mmol) of objective 6-(4-vinylphenyl)-2,4-hexanedione as brown liquid. Yield: 56%. Identification was performed by CHN elemental analysis and $^1$H-NMR. $^1$H NMR: enol; δ 7.33 (d, J = 8.1 Hz, 2 H, aromatic), 7.14 (d, J = 8.4 Hz, 2 H, aromatic), 6.68 (dd, J = 8.1 Hz, 1 H, vinylic), 5.70 (d, J = 17.0 Hz, 1 H, vinylic), 5.46 (s, 1 H, enol-methine), 5.20 (d, J = 11.1 Hz, 1 H, vinylic), 2.91 (t, J = 5.7 Hz, 2 H, methylene), 2.58 (t, J = 7.3 Hz, 2 H, methylene), 2.03 (s, 3 H, methyl). keto; δ 7.33 (d, J = 8.1 Hz, 2 H, aromatic), 7.14 (d, J = 8.4 Hz, 2 H, aromatic), 6.68 (dd, J = 8.1 Hz, 1 H, vinylic), 5.70 (d, J = 17.0 Hz, 1 H, vinylic), 5.20 (d, J = 11.1 Hz, 1 H, vinylic), 3.53 (s, 2 H, $C(=O)CH_2C(=O)$), 2.89 (m, 4 H, ethylene), 2.19 (s, 3 H, methyl). enol : keto =6:1. E.A.: Calcd for $C_{14}H_9O_2$ : C, 77.75; H, 7.46. Found: C, 77.49; H, 7.52.

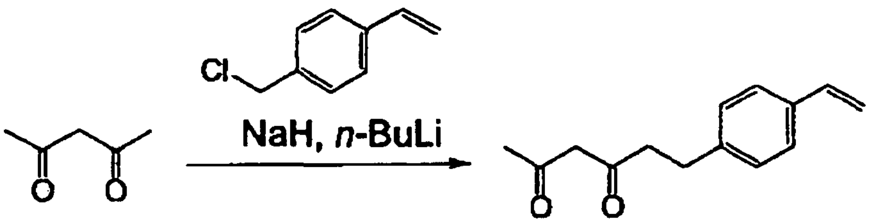


(14)

Subsequently, as shown in scheme (15), this 6-(4-vinylphenyl)-2,4-hexanedione and di (μ-chloro)tetrakis(2-(2-pyridyl)benzothienyl) iridium (simplified as $[Ir(btp)_2Cl]_2$ below) synthesized according to a usual method (for example, described in S. Lamansky, et al., Inorganic Chemistry, 40, 1704 (2001)) were reacted to synthesize $Ir(btp)_2$[1-(St-Me)-acac]. That is, 253 mg (0.20 mmol) of $[Ir(btp)_2Cl]_2$ was suspended in 10 ml of N,N-dimethylformamide (simplified as DMF below), 161mg (0.74 mmol) of 6-(4-vinylphenyl)-2,4-hexanedione, 64 mg of sodium carbonate, and 1.9 mg (0.0086 mmol) of 2,6-di-tert-butyl-4-methylphenol (simplified as BHT below) were added, and steering with heating was performed for 1 hour at 80 °C. 100 ml of water and 50 ml of chloroform were added into the obtained reaction mixture and shaken well, and after the organic phase was dried over magnesium sulfate, exsiccation under reduced pressure was performed by a rotary evaporator. Then, the crude purified one was purified with dichloromethane as an eluate in a silica gel column to obtain a reddish brown solution. This solution was concentrated under reduced pressure, hexane was added, and recrystallization was performed at -20 °C to obtain 153 mg (0.18 mmol) of objective $Ir(btp)_2$[1-(StMe)-acac] as a reddish brown solid (yield: 47 %). Identification was performed by CHN elemental analysis and $^1$H-NMR. $^1$H NMR: δ 8.40 (d, J = 5.4 Hz, 1 H, btp), 7.97 (d, J = 5.4 Hz, 1 H, btp), 7.65 (m, 6 H, btp), 7.1 - 6.7 (m, 10 H, aromatic), 6.63 (dd, J = 17.8, 11.1 Hz, 1H, vinylic), 6.24 (d, J = 8.1 Hz, 1 H, btp), 6.16 (d, J = 7.8 Hz, 1 H, btp), 5.65 (d, J = 17.8 Hz, 1 H, vinylic), 5.22 (s, 1 H, diketonate-methine), 5.18 (d, J = 11.1 Hz, 1 H, vinylic), 2.56 (m, 2 H, ethylene), 2.37 (m, 2 H, ethylene), 1.75 (s, 3 H, methyl). E.A.: Calcd for $C_{40}H_{31}IrN_2O_2S_2$ : C, 58.02; H, 3.77; N, 3.38. Found: C, 57.79; H, 3.81; N, 3.55.

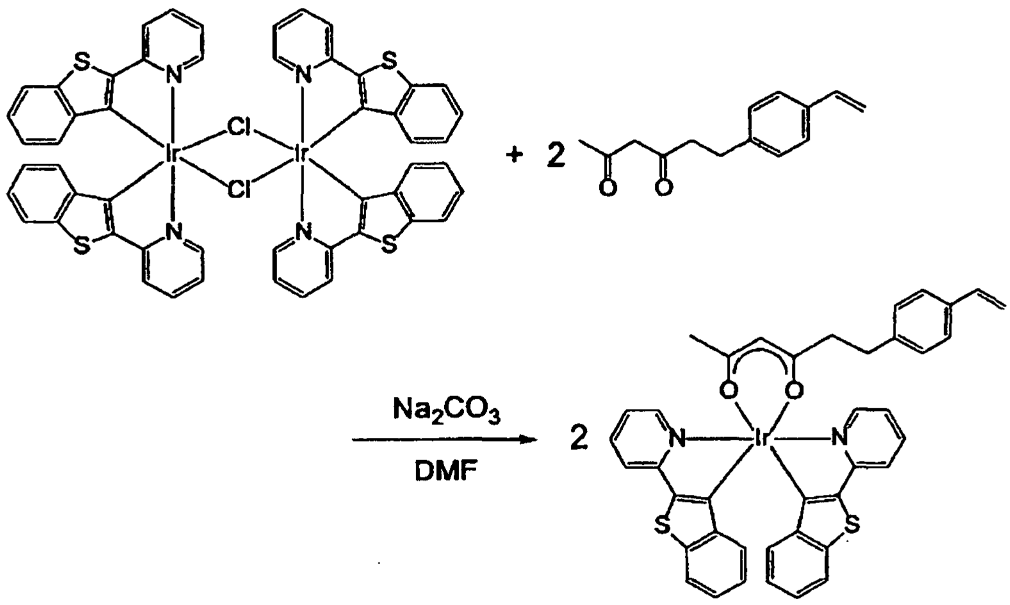

(15)

(Example 6-4) Synthesis of white phosphorescent compound

A copolymer containing three kinds of monomers having emission function synthesized in examples 6-1 to 6-3 and N-vinylcarbazole having hole transporting function was synthesized.

1.55 g (8.0 mmol) of N-vinylcarbazole, 58.0 mg (0.08 mmol) of Ir(2,4-F-ppy)$_2$(3-ST-pic), 1.1 mg (0.0015 mmol) of Ir(ppy)$_2$[1-(ST-Me)-acac], 1.2 mg (0.0015 mmol) of Ir(btp)$_2$[1-(StMe)-acac], and 13 mg (0.08 mmol) of AIBN were dissolved into 40 ml of dried toluene and argon was further insufflated for 1 hour. The temperature of this solution was elevated to 80 °C, polymerization reaction was initiated, and steering was performed for 8 hours as it stood. After cooling down, the reacted liquid was dropped into 250 ml of methanol and a polymer was precipitated and recovered by filtration. Furthermore, after purification by dissolving the recovered polymer into 25 ml of chloroform and dropping this solution into 250 ml of methanol to reprecipitate, vacuum drying was performed for 12 hours at 60 °C to obtain 116.3 mg of the objective white phosphorescent compound having three kinds of phosphorescent sites radiating in blue, green, and red colors.

From the result of Ir elemental analysis for the obtained copolymer (phosphorescent compound), the content of Ir complex (phosphorescent unit) was 1.07 mol%. Also, from GPC for the copolymer in chloroform, weight-average molecular weight was 12400 relative to the polystyrene standard.

(Example 6-5) Fabrication of an organic light-emitting device

An organic light-emitting device was fabricated as similar to example 1-3 except using the copolymer synthesized in example 6-2 instead of Ir(MPPy)(PrCOPPy)$_2$ / VCz copolymer.

As a positive electrical voltage was applied on the ITO-side of this organic light-emitting device and a negative electrical voltage was applied on the Al-side, white luminescence was observed with the naked eye.

An emission spectrum for the organic light-emitting device is shown in FIG. 3. Peaks of emission corresponding to three kinds of phosphorescent units (blue, green, and red) were observed at 480 nm, 520 nm, and 620 nm, respectively. The chromaticity of the luminescence color was (0.32, 0.33).

(Example 7-1) Synthesis of the monomer having a blue phosphorescent site; iridium(III) bis(2-(2,4-difluorophenyl)pyridinato)(3-(4-vinylphenyl)methoxypicolinato) (simplified as Ir(2,4-F-ppy)$_2$(3-ST-pic) below)

As shown in scheme (16), 2-(2,4-difluorophenyl)pyridine was synthesized. That is, 8.69 g (55.0 mmol) of 2-brormopyridine was dissolved into 200 ml of dried tetrahydrofuran under argon gas stream, cooling was performed to -78 °C, 38.7 ml (61.9 mmol) of a 1.6 M solution of n-butyl lithium in hexane was dropped for 30 minutes. After dropping, a solution in which 7.5 g (55.0 mmol) of zinc chloride was dissolved into 50ml of dried tetrahydrofuran (THF) was further dropped for 30 minutes. After dropping, temperature was elevated to 0 °C slowly, 9.65 g (55.0 mmol) of 1-bromo-2,4-difluorobenzene and 2.31 g (2.0 mmol) of tetrakis(triphenylphosphine) palladium (0) were added, and after steering was performed for 6 hours under reflux, 200 ml of saturated saline solution was added into the reacted liquid and extraction

was performed with diethyl ether. After the extracted liquid was dried, concentrated, and purified by means of column chromatography (silica gel; chloroform : hexane =1:1 (volume ratio)) to obtain 2-(2,4-difluorophenyl)pyridine as colorless transparent oil. Yield: 6.00 g. Yield: 63 %. Identification was performed by $^1$H-NMR and CHN elemental analysis. $^1$H-NMR(270 MHz, $CDCl_3$), ppm: 8.71(d, 1H, J = 4.6 Hz), 8.00 (td, 1H, J = 8.9, 6.5 Hz), 7. 8 - 7.7 (m, 2H), 7.3 - 7.2(over wrapped with $CHCl_3$, 1H), 7.1 - 6.8(m, 2H). Anal. Found: C 68.98, H 3.80, N 7.31. Calcd: C 69.11, H 3.69, N 7.33.

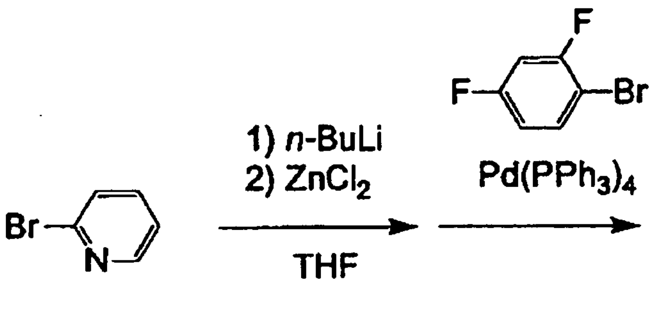


(16)

Subsequently, as shown in scheme (17), a binuclear complex of iridium, i.e. bis(μ-chloro)tetrakis(2-(2,4-difluorophenyl)pyridine) diiridium(III) (simplified as $(Ir(2,4\text{-}F\text{-}ppy)_2Cl]_2$ below) was synthesized. That is, 0.96 g (5.0 mmol) of 2-(2,4-difluorophenyl)pyridine and 1.00 g of sodium hexachloroiridiumate(III) n-hydrates (produced by Wako Pure Chemical Industries, Ltd.) were dissolved into 40 ml of a mixed solvent of 2-ethoxyethanol : water = 3 : 1, and after argon was insufflated for 30 minutes, steering was performed for 5 hours under reflux. The produced precipitate was filtered, washed with ethanol and a small amount of acetone, and dried for 5 hours under vacuum, to obtain $[Ir(2,4\text{-}F\text{-}ppy)_2Cl]_2$ as yellow powder. Yield: 0.79 g Yield: 86 %. Identification was performed by $^1$H-NMR and CHN elemental analysis. $^1$H-NMR(270 MHz, $CDCl_3$), ppm: 9.12(d, 4H, J = 5.7 Hz), 8.31(d, 4H, J = 8.6 Hz), 7.83(dd, 4H, J = 7.6, 7.6 Hz), 6.82(dd, 4H, J = 7.3, 7.3 Hz), 6.34(ddd, 4H, J = 11.6, 10.0, 2.4 Hz), 5.29(dd, 4H, J = 9.5, 2.4 Hz). Anal. Found: C 43.69, H 3.53, N 3.54. Calcd: C 43.88, H 3.45, N 3.56.

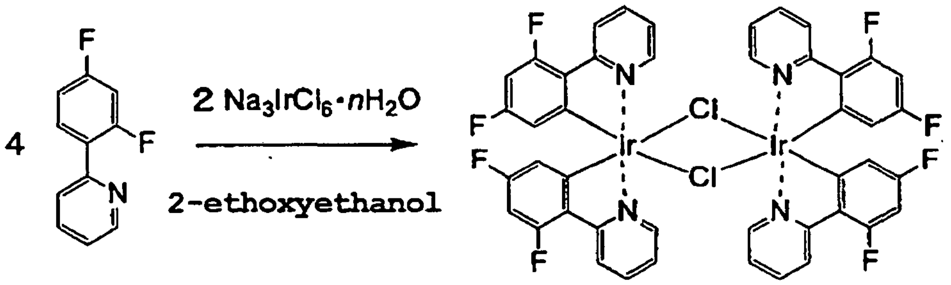


(17)

Subsequently, as shown in scheme (18), iridium(III) bis(2-(2,4-difluorophenyl)pyridinato)(3-hydroxypicolinato) (simplified as $Ir(2,4\text{-}F\text{-}ppy)_2(3\text{-}OH\text{-}pic)$ below) was synthesized. That is, 10 ml of dried N,N-dimethylformamide (DMF) was added to 121.6 mg (0.1 mmol) of $[Ir(2,4\text{-}F\text{-}ppy)_2Cl]_2$, 41.7 mg (0.3 mmol) of 3-hydroxypicolinic acid, 106.0 mg (1.0 mmol) of sodium carbonate under argon gas stream and steering was performed for 2 hours at 80 °C. After 50 ml of water was added into the reacted liquid, extraction with ethyl acetate was performed. After the solution was dried over magnesium sulfate, concentrated, and purified by means of column chromatography (silica gel, methanol : chloroform = 3 : 97 (volume ratio)). Furthermore, it was recrystallized from hexane / chloroform to obtain 101.0 mg of $Ir(2,4\text{-}F\text{-}ppy)_2(3\text{-}OH\text{-}pic)$ as a yellow crystal. Yield: 71 %. Identification was performed by $^1$H-NMR and CHN elemental analysis. $^1$H-NMR(270 MHz, DMSO-$d_6$), ppm: 13.6(br, 1H), 8.50(d, 1H, J = 5.9 Hz), 8.25(d, 2H, J = 11.1 Hz), 8.1 - 8.0(m, 2H), 7.69(d, 1H, J = 5.7 Hz), 7.62(d, 1H, J = 8.1 Hz), 7.53(d, 1H, J = 4.6 Hz), 7.50(d, 1H, J = 5.7 Hz), 7.36(t, 1H, J = 4.5 Hz), 7.24(d, 1H, J = 5.1 Hz), 6.9 - 6.7(m, 2H), 5.66(dd, 1H, J = 8.6, 2.4 Hz), 5.48(dd, 1H, J = 8.6, 2.4 Hz). Anal. Found: C 47.29, H 2.33, N 5.86. Calcd: C 47.32, H 2.27, N 5.91.

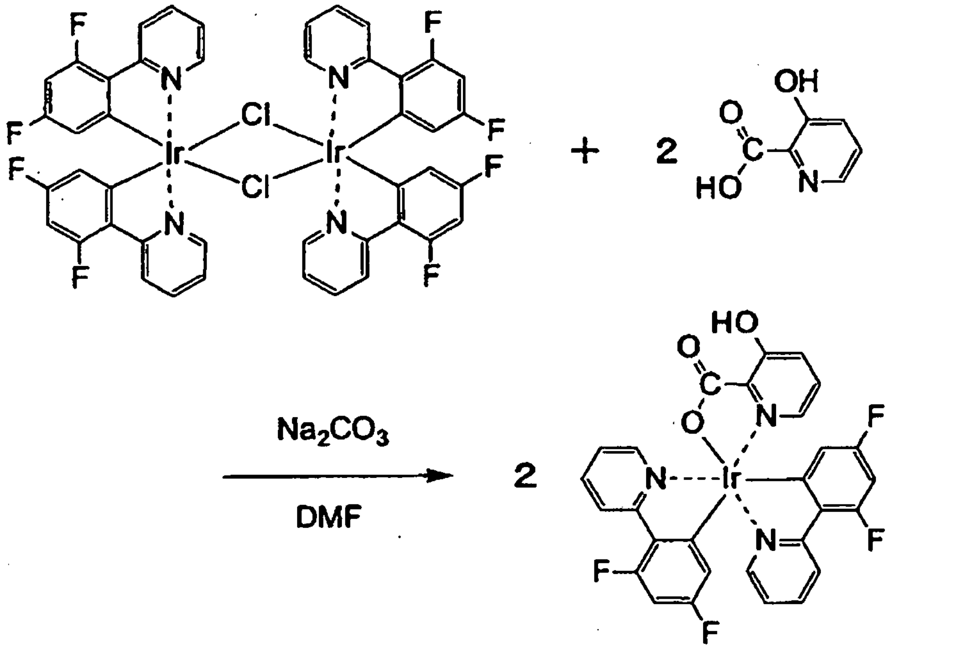


(18)

Subsequently, As shown in scheme (19), $Ir(2,4\text{-}F\text{-}ppy)_2(3\text{-}ST\text{-}pic)$ was synthesized. That is, 15 ml of dried N,N-dimethylformamide was added to 106.5 mg (0.15 mmol) of $Ir(2,4\text{-}F\text{-}ppy)_2(3\text{-}OH\text{-}pic)$, 207.3 mg (1.5 mmol) of potassium carbonate, and 0.3 mg of 2,6-di-t-butylhydroxytoluene under argon gas stream, 91.5 mg (0.6 mmol) of 4-vinylbenzylchloride was further added, and steering was performed for 4 hours at 80 °C. 100 ml of water was added into the reacted liquid, and a product was precipitated, filtrated, and purified by means of column chromatography (silica gel, methanol : chloroform = 3 : 97 (volume ratio)). Furthermore, it was recrystallized from hexane / chloroform to obtain 72.0 mg of $Ir(2,4\text{-}F\text{-}ppy)_2(3\text{-}ST\text{-}pic)$ as a yellow crystal. Yield: 58 %. Identification was performed by $^1H$-NMR and CHN elemental analysis. $^1H$-NMR(270 MHz, DMSO-$d_6$), ppm: 8.59(d, 1H, J = 5.1 Hz), 8.3 - 8.2(m, 2H), 8.1 - 8.0(m, 2H), 7.9(d, 1H, J = 8.6 Hz), 7.67(d, 1H, J = 5.1 Hz), 7.6 - 7.3(m, 7H), 6.9 - 6.7(m, 3H), 5.85(d, 1H, J = 17.8 Hz), 5.67(dd, 1H, J = 8.9, 2.4 Hz), 5.45(dd, 1H, J = 8.9, 2.4 Hz), 5.29(s, 2H), 5.27(d, 1H, J = 11.1 Hz). Anal. Found: C 53.71, H 2.90, N 5.03. Calcd: C 53.75, H 2.93, N 5.08.

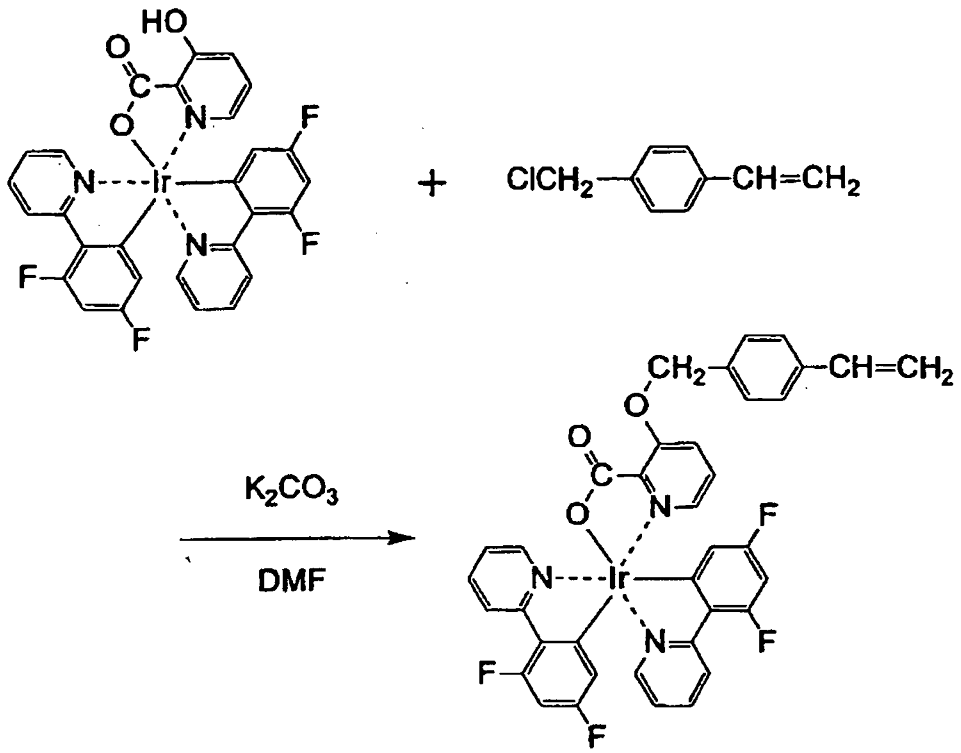


(19)

(Example 7-2) Synthesis of copolymer of $Ir(2,4\text{-}F\text{-}ppy)_2(3\text{-}ST\text{-}pic)$ having a blue phosphorescent site and vinylcarbazole having a hole transporting function (simplified as $Ir(2,4\text{-}F\text{-}ppy)_2(3\text{-}ST\text{-}pic)$ / VCz copolymer below)

966 mg (5.0 mmol) of N-vinylcarbazole, 41(0.05 mmol) of $Ir(2,4\text{-}F\text{-}ppy)_2(3\text{-}ST\text{-}pic)$ synthesized in example 7-1, and 8.2 mg (0.05 mmol) of AIBN were dissolved into 25 ml of dried toluene and argon was further insufflated for 1 hour. The temperature of this solution was elevated to 80 °C, polymerization reaction was initiated, and steering was performed for 8 hours as it stood. After cooling down, the reacted liquid was dropped into 250 ml of methanol and a polymer was precipitated and recovered by filtration. Furthermore, after purification by dissolving the recovered polymer into 25 ml of chloroform and dropping this solution into 250 ml of methanol to reprecipitate, vacuum drying was performed for 12 hours at 60 °C to obtain 722 mg of the objective $Ir(2,4\text{-}F\text{-}ppy)_2(3\text{-}ST\text{-}pic)$ / VCz copolymer.

From the result of Ir elemental analysis for the obtained copolymer (phosphorescent compound), the content of Ir complex (phosphorescent unit) was 1.04 mol%. Also, from GPC for the copolymer in chloroform, weight-average molecular weight was 11400 relative to the polystyrene standard.

(Example 7-3) Synthesis of copolymer of [6-(4-vinylphenyl)-2,4-hexanedionato]bis[2-(2-pyridyl)benzothienyl] iridium(III) having a red phosphorescent site and vinylcarbazole having a hole transporting function (simplified as $Ir(btp)_2$[1-(ST-Me)-acac] / VCz copolymer below)

1.55 g (8.0 mmol) of N-vinylcarbazole, 33.1 mg (0.04 mmol) of $Ir(btp)_2$[1-(STMe)-acac] synthesized in example 6-3, and 13 mg (0.08 mmol) of AIBN were dissolved into 40 ml of dried toluene and argon was further insufflated for 1 hour. The temperature of this solution was elevated to 80 °C, polymerization reaction was initiated, and steering was performed for 8 hours as it stood. After cooling down, the reacted liquid was dropped into 250 ml of methanol and a polymer was precipitated and recovered by filtration. Furthermore, after purification by dissolving the recovered polymer into 25 ml of chloroform and dropping this solution into 250ml of methanol to reprecipitate, vacuum drying was performed for 12 hours at 60 °C to obtain 1.12 g of the objective $Ir(btp)_2$[1-(STMe)-acac] / VCz copolymer.

From the result of Ir elemental analysis for the obtained copolymer (phosphorescent compound), the content of Ir complex (phosphorescent unit) was 0.59 mol%. Also, from GPC for the copolymer in chloroform, weight-average molecular weight was 10800 relative to the polystyrene standard.

(Example 7-4) Fabrication of an organic light-emitting device

A solution of $Ir(2,4\text{-}F\text{-}ppy)_2(3\text{-}ST\text{-}pic)$ / VCz coplymer synthesized in example 7-2, $Ir(btp)_2$[1-(STMe)-acac] / VCz copolymer synthesized in example 7-3, and tBu-PBD in chloroform was prepared. The proportions were 66.85 percent by mass for $Ir(2,4\text{-}F\text{-}ppy)_2(3\text{-}ST\text{-}pic)$ / VCz coplymer, 3.15 percent by mass for $Ir(btp)_2$[1-(STMe)-acac] / VCz copolymer, and 30.0 percent by mass for tBu-PBD.

This solution was spin-coated on a glass substrate with ITO to form a film with the thickness of 100 nm, and 10 nm of Ca and 100 nm of Al were deposited on it by a vacuum evaporation to provide a cathode.

As a positive electrical voltage was applied on the ITO-side of the obtained organic light-emitting device and a negative electrical voltage was applied on the Al-side, white luminescence was observed with the naked eye.

An emission spectrum for the organic light-emitting device is shown in FIG. 4. Peaks of emission corresponding to $Ir(2,4\text{-}F\text{-}ppy)_2(3\text{-}ST\text{-}pic)$ / VCz coplymer and $Ir(btp)_2$[1-(STMe)-acac] / VCz copolymer were observed at near 480 nm and near 620 nm, respectively. The chromaticity of the luminescence color was (0.30, 0.35).

## Claims

1. A non-ionic organic polymeric phosphorescent compound emitting phosphorescence for use in an organic light-emitting device, comprising phosphorescent repeat units for emitting phosphorescence and a carrier transporting repeat unit for transporting a carrier, **characterized in that** a repeat number m for the phosphorescent unit(s) and a repeat number n for the carriertransporting unit(s) satisfy a relationship of $m < n$, and
**characterized in that** the phosphorescent repeat units consist of three kinds radiating in blue with a spectral peak wavelength in 400 through 490 nm, green with a spectral peak wavelength in 490 through 570 nm, and red with a spectral peak wavelength in 570 through 700 nm, and the phosphorescent compound radiates in white, wherein the phosphorescent sites of the phosphorescent repeat units are a monovalent group or a divalent group of a complex with a transition metal or a rare earth metal and
a carrier transporting site of the carrier transporting repeat unit comprises at least one kind of group selected from the group consisting of monovalent groups of carbazole, monovalent groups of tertiary amine, monovalent groups of imidazole derivatives, monovalent groups of triazole derivatives, monovalent groups of oxadiazole derivatives,

divalent groups of styrene, and divalent groups of fluorene and groups in which these groups are substituted with a substituent.

2. The phosphorescent compound as claimed in claim 1, **characterized in that** $0.0001 \leq m/(m+n) \leq 0.2$.

3. The phosphorescent compound as claimed in claim 1 or 2, **characterized by** being soluble in an organic solvent or water.

4. The phosphorescent compound as claimed in any one of claims 1 to 3, **characterized in that**
the monovalent group of the complex with the transition metal or the rare earth metal bonds, as a side chain through a spacer portion, to a main chain and
the spacer portion comprises an organic group in which the number of carbon atoms is 1 through 30 and a hetero atom may be contained or an inorganic group in which the number of hetero atoms is 1 through 10 and a carbon atom is not contained.

5. A phosphorescent composition **characterized in that** the phosphorescent compound as claimed in any one of claims 1 to 4 and a carrier transporting polymer compound are compounded.

6. The phosphorescent composition as claimed in claim 5, **characterized in that** the carrier transporting polymer compound is a hole transporting polymer compound.

7. The phosphorescent composition as claimed in claim 5, **characterized in that** the carrier transporting polymer compound is an electron transporting polymer compound.

8. An organic light-emitting device having one or more organic polymer layers interposed between an anode and a cathode, **characterized in that** at least one layer of the organic polymer layers comprises the phosphorescent compound as claimed in any one of claims 1 to 4 or the phosphorescent composition as claimed in any of claims 5 to 7.

9. The organic light-emitting device as claimed in claim 8, **characterized in that** the anode is formed on a plastic substrate.

10. The organic light-emitting device as claimed in claim 8 or 9 **characterized in that** the organic polymer layer is formed by an ink-jet method or a printing method.

11. A display apparatus having a display screen, **characterized in that**
each pixel of the display screen comprises the organic light-emitting device as claimed in any of claims 8 through 10, and
each pixel has two or more transistors.

**Patentansprüche**

1. Phosphoreszenz-emittiernde nicht-ionische organische, polymere phosphoreszierende Verbindung für die Verwendung in einer lichtemittierenden Vorrichtung, welche phosphoreszierende Wiederholungseinheiten für das Emittieren von Phosphoreszenz und Trägertransportwiederholungseinheiten für den Transport eines Trägers umfasst, **dadurch gekennzeichnet, dass** die Wiederholungszahl m für die phosphoreszierende(n) Einheit(en) und die Wiederholungszahl n für die Trägertransporteinheit(en) die Beziehung $m < n$ erfüllt, und **dadurch gekennzeichnet, dass** die phosphoreszierenden Wiederholungseinheiten aus drei Arten bestehen, die mit einem spektralen Wellenlängenpeak von 400 bis 490 nm blau strahlen, mit einem spektralen Wellenlängenpeak von 490 bis 500 nm grün strahlen und mit einem spektralen Wellenlängenpeak von 570 bis 700 nm rot strahlen, und die phosphoreszierende Verbindung weiß strahlt, wobei
die phosphoreszierenden Stellen der phosphoreszierenden Wiederholungseinheiten eine einwertige Gruppe oder eine zweiwertige Gruppe eines Komplexes mit einem Übergangsmetall oder einem Seltenerdmetall sind und
eine Trägertransportstelle der Trägertransportwiederholungseinheit mindestens eine Art einer Gruppe umfasst, die ausgewählt ist unter der Gruppe, die aus einwertigen Gruppen von Carbazol, einwertigen Gruppen eines tertiären Amins, einwertigen Gruppen von Imidazolderivaten, einwertigen Gruppen von Triazolderivaten, einwertigen Gruppen von Oxadiazolderivaten, zweiwertigen Gruppen von Styrol, zweiwertigen Gruppen von Fluoren und Gruppen, in denen diese Gruppen mit einem Substituenten substituiert sind, besteht.

2. Phosphoreszierende Verbindung nach Anspruch 1, **dadurch gekennzeichnet, dass** 0,0001 ≤ m/(m+n) ≤ 0,2 ist.

3. Phosphoreszierende Verbindung nach Anspruch 1 oder 2, **dadurch gekennzeichnet, dass** sie in einem organischen Lösungsmittel oder Wasser löslich ist.

4. Phosphoreszierende Verbindung nach einem der Ansprüche 1 bis 3, **dadurch gekennzeichnet, dass** die einwertige Gruppe des Komplexes mit dem Übergangsmetall oder dem Seltenerdmetall als eine Seitenkette über einen Abstandsteil an eine Hauptkette bindet und der Abstandsteil eine organische Gruppe, in der die Zahl der Kohlenstoffatome 1 bis 30 ist und ein Heteroatom enthalten sein kann, oder eine anorganische Gruppe umfasst, in der die Zahl der Heteroatome 1 bis 10 ist und ein Kohlenstoffatom nicht enthalten ist,.

5. Phosphoreszierende Zusammensetzung, **dadurch gekennzeichnet, dass** die phosphoreszierende Verbindung nach einem der Ansprüche 1 bis 4 und eine Trägertransportpolymerverbindung vermischt sind.

6. Phosphoreszierende Zusammensetzung nach Anspruch 5, **dadurch gekennzeichnet, dass** die Trägertransportpolymerverbindung eine Lochtransportpolymerverbindung ist.

7. Phosphoreszierende Zusammensetzung nach Anspruch 5, **dadurch gekennzeichnet, dass** die Trägertransportpolymerverbindung eine Elektronentransportpolymerverbindung ist.

8. Organische lichtemittierende Vorrichtung, die eine oder mehrere organische Polymerschichten zwischen einer Anode und einer Kathode angeordnet aufweist, **dadurch gekennzeichnet, dass** mindestens eine Schicht der organischen Polymerschichten die phosphoreszierende Verbindung nach einem der Ansprüche 1 bis 4 oder die phosphoreszierende Zusammensetzung nach einem der Ansprüche 5 bis 7 umfasst.

9. Organische lichtemittierende Vorrichtung nach Anspruch 8, **dadurch gekennzeichnet, dass** die Anode auf einem Kunststoffsubstrat gebildet ist.

10. Organische lichtemittierende Vorrichtung nach Anspruch 8 oder 9, **dadurch gekennzeichnet, dass** die organische Polymerschicht durch ein Tintenstrahlverfahren oder ein Druckverfahren gebildet ist.

11. Anzeigevorrichtung mit einem Anzeigeschirm, **dadurch gekennzeichnet, dass**
jedes Pixel des Anzeigeschirms die organische lichtemittierende Vorrichtung nach einem der Ansprüche 8 bis 10 umfasst und
jedes Pixel zwei oder mehr Transistoren aufweist.

**Revendications**

1. Composé phosphorescent polymère organique non-ionique émettant une phosphorescence pour une utilisation dans un dispositif émettant de la lumière organique, comprenant des unités répétitives phosphorescentes pour émettre une phosphorescence et une unité répétitive de transport de support pour le transport d'un support, **caractérisé en ce qu'**un nombre de répétitions n pour la(les) unité(s) phosphorescente(s) et un nombre de répétitions n pour la(les) unité(s) de transport de support satisfont une relation de m < n, et
**caractérisé en ce que** les unités répétitives phosphorescentes sont constituées de trois types rayonnant en bleu avec une longueur d'onde de pic spectral dans 400 à 490 nm, en vert avec une longueur d'onde de pic spectral dans 490 à 570 nm, et en rouge avec une longueur d'onde de pic spectral dans 570 à 700 nm, et le composé phosphorescent rayonne en blanc, dans lequel
les sites phosphorescents des unités répétitives phosphorescentes sont un groupe monovalent ou un groupe divalent d'un complexe avec un métal de transition ou un métal de terres rares et
un site de transport de support de l'unité répétitive de transport de support comprend au moins un type de groupe choisi parmi
le groupe constitué de groupes monovalents de carbazole, de groupes monovalents d'amine tertiaire, de groupes monovalents de dérivés d'imidazole, de groupes monovalents de dérivés de triazole, de groupes monovalents de dérivés d'oxadiazole, de groupes divalents de styrène, et de groupes divalents de fluorène et
des groupes dans lesquels ces groupes sont substitués avec un substituant.

2. Composé phosphorescent selon la revendication 1, **caractérisé en ce que** 0,0001 ≤ m/(m+n) ≤ 0,2.

3. Composé phosphorescent selon la revendication 1 ou 2, **caractérisé en ce qu'**il est soluble dans un solvant organique ou dans l'eau.

4. Composé phosphorescent selon l'une quelconque des revendications 1 à 3, **caractérisé en ce que**
le groupe monovalent du complexe avec le métal de transition ou le métal de terres rares est lié, comme une chaîne latérale par l'intermédiaire d'une portion d'espacement, à une chaîne principale et
la portion d'espacement comprend un groupe organique dans lequel le nombre d'atomes de carbone est de 1 à 30 et un hétéroatome peut être contenu ou un groupe inorganique dans lequel le nombre d'hétéroatomes est de 1 à 10 et un atome de carbone n'est pas contenu.

5. Composition phosphorescente **caractérisée en ce que** le composé phosphorescent selon l'une quelconque des revendications 1 à 4 et un composé polymère de transport de support sont combinés.

6. Composition phosphorescente selon la revendication 5, **caractérisée en ce que** le composé polymère de transport de support est un composé polymère de transport de trous.

7. Composition phosphorescente selon la revendication 5, **caractérisée en ce que** le composé polymère de transport de support est un composé polymère de transport d'électrons.

8. Dispositif émettant de la lumière organique présentant une ou plusieurs couches polymères organiques intercalées entre une anode et une cathode, **caractérisé en ce qu'**au moins une couche des couches polymères organiques comprend le composé phosphorescent selon l'une quelconque des revendications 1 à 4 ou la composition phosphorescente selon l'une quelconque des revendications 5 à 7.

9. Dispositif émettant de la lumière organique selon la revendication 8, **caractérisé en ce que** l'anode est formée sur un substrat en matière plastique.

10. Dispositif émettant de la lumière organique selon la revendication 8 ou 9, **caractérisé en ce que** la couche polymère organique est formée par un procédé à jet d'encre ou un procédé d'impression.

11. Appareil d'affichage présentant un écran d'affichage, **caractérisé en ce que**
chaque pixel de l'écran d'affichage comprend le dispositif émettant de la lumière organique selon l'une quelconque des revendications 8 à 10, et
chaque pixel présente deux ou plusieurs transistors.

FIG.1

(A)

(B)

(C)

(D)

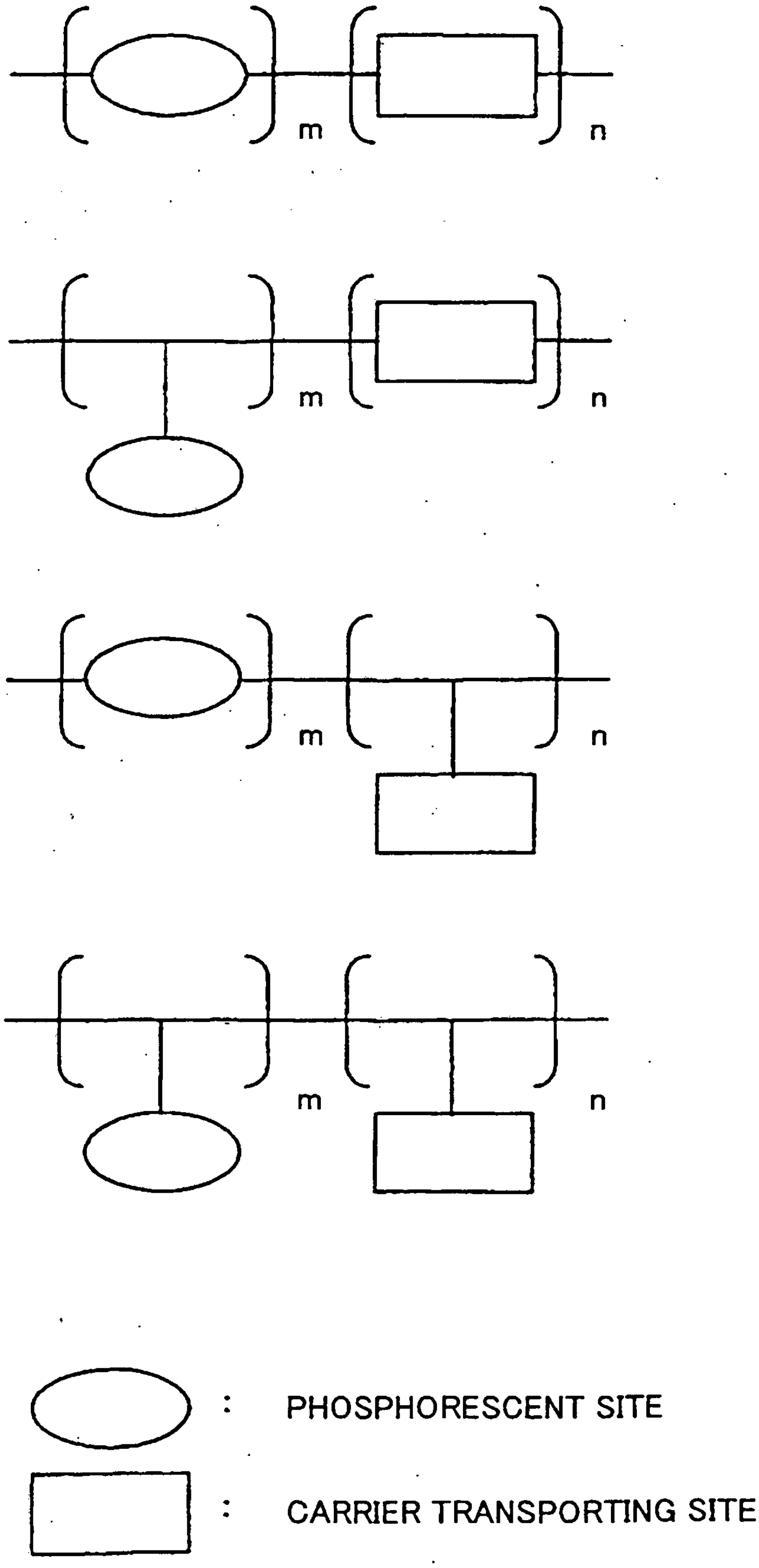

FIG.2

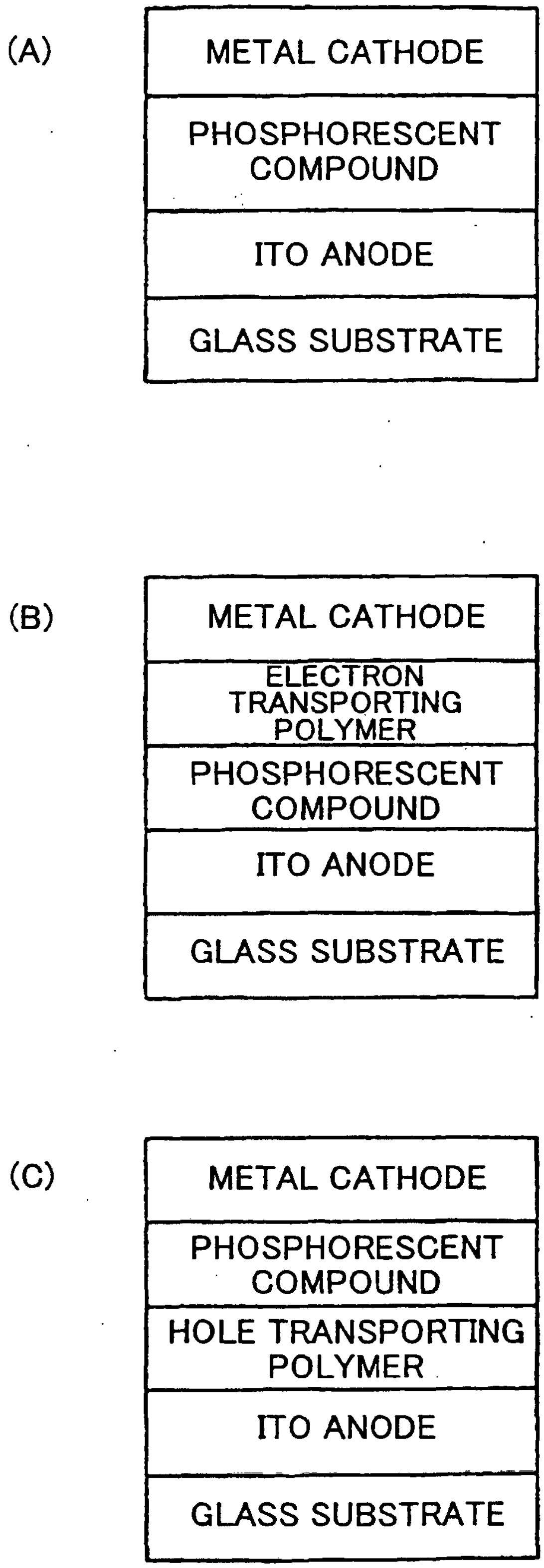
(A)
METAL CATHODE
PHOSPHORESCENT COMPOUND
ITO ANODE
GLASS SUBSTRATE
(B)
METAL CATHODE
ELECTRON TRANSPORTING POLYMER
PHOSPHORESCENT COMPOUND
ITO ANODE
GLASS SUBSTRATE
(C)
METAL CATHODE
PHOSPHORESCENT COMPOUND
HOLE TRANSPORTING POLYMER
ITO ANODE
GLASS SUBSTRATE

FIG.3

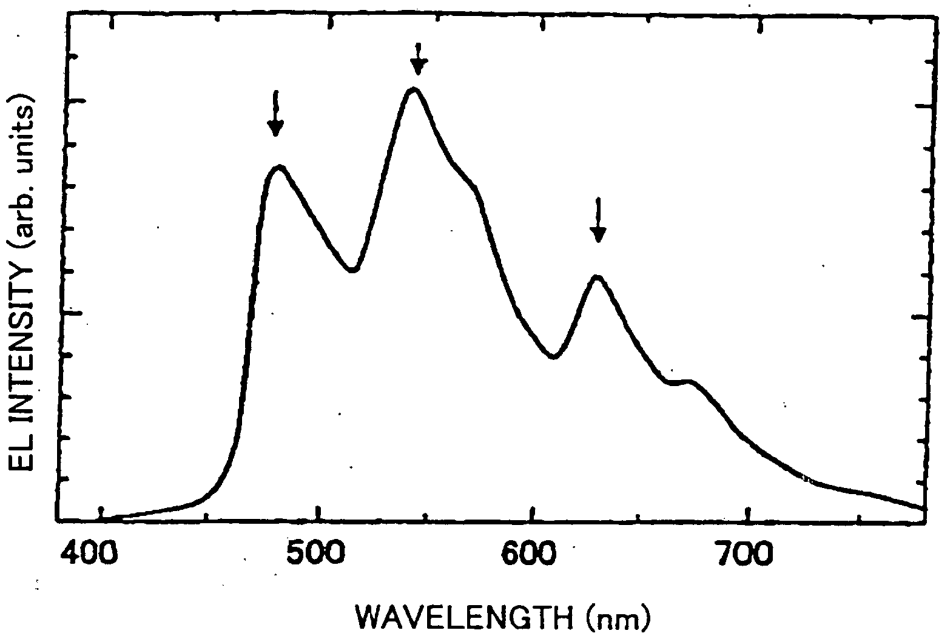
EL INTENSITY (arb. units)
400
500
600
700
WAVELENGTH (nm)

FIG.4

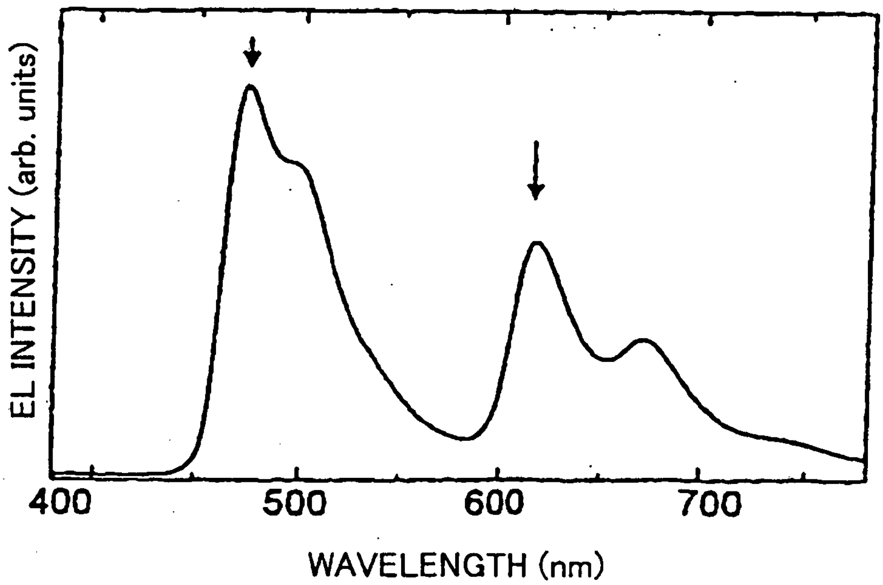
EL INTENSITY (arb. units)
400
500
600
700
WAVELENGTH (nm)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20010015432 A
- JP 8157575 A
- JP 10001665 A
- JP 2015595 A
- JP 5121172 A

### Non-patent literature cited in the description


- *Appl. Phys. Lett.,* 2000, vol. 77, 904
- *Jpn. J. Appl. Phys,* 2000, vol. 39, L28
- *J. Mater. Chem.,* 1999, vol. 9, 2103
- **LAMANSKY.** *Inorganic Chemistry,* 2001, vol. 40, 1704
- **S. LAMANSKY et al.** *Inorganic Chemistry,* 2001, vol. 40, 1704